(19) Europäisches Patentamt
European Patent Office
Office européen des brevets

(11) EP 2 620 279 B1

(12) # EUROPEAN PATENT SPECIFICATION

(45) Date of publication and mention of the grant of the patent:
**19.07.2017 Bulletin 2017/29**

(21) Application number: **11826832.5**

(22) Date of filing: **20.09.2011**

(51) Int Cl.:
***H01L 21/223*** (2006.01) ***C23C 14/48*** (2006.01)
***C23C 14/06*** (2006.01) ***C08J 7/12*** (2006.01)
***C08J 7/04*** (2006.01)

(86) International application number:
**PCT/JP2011/071353**

(87) International publication number:
**WO 2012/039387 (29.03.2012 Gazette 2012/13)**

(54) **FORMED BODY, PRODUCTION METHOD THEREOF, ELECTRONIC DEVICE MEMBER AND ELECTRONIC DEVICE**

FORMKÖRPER, VERFAHREN ZU DESSEN HERSTELLUNG, ELEMENT FÜR EINE ELEKTRONISCHE VORRICHTUNG UND ELEKTRONISCHE VORRICHTUNG

CORPS FORMÉ, PROCÉDÉ DE FABRICATION ASSOCIÉ, ÉLÉMENT POUR DISPOSITIFS ÉLECTRONIQUES ET DISPOSITIF ÉLECTRONIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.09.2010 JP 2010210658**
**21.09.2010 JP 2010211129**

(43) Date of publication of application:
**31.07.2013 Bulletin 2013/31**

(73) Proprietor: **Lintec Corporation**
**Tokyo 173-0001 (JP)**

(72) Inventors:
- **SUZUKI Yuta**
**Tokyo 173-0001 (JP)**
- **KONDO Takeshi**
**Tokyo 173-0001 (JP)**

(74) Representative: **Beckmann, Claus et al**
**Kraus & Weisert**
**Patentanwälte PartGmbB**
**Thomas-Wimmer-Ring 15**
**80539 München (DE)**

(56) References cited:

| | |
|---|---|
| **EP-A1- 2 357 078** | **WO-A1-2010/067857** |
| **JP-A- 2000 246 830** | **JP-A- 2002 105 676** |
| **JP-A- 2004 119 138** | **JP-A- 2006 070 238** |
| **JP-A- 2008 204 683** | **JP-A- 2008 235 165** |

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).



Printed by Jouve, 75001 PARIS (FR)

**Description**

TECHNICAL FIELD

The invention relates to a formed article, a method for producing the same, an electronic device member that includes the formed article, and an electronic device that includes the electronic device member.

BACKGROUND ART

In recent years, attempts have been made to produce a flexible display using a synthetic resin sheet instead of a glass substrate. However, since a synthetic resin sheet easily allows gas (e.g., water vapor) to pass through as compared with glass, and has poor surface flatness, a number of problems exist when producing a flexible display using a synthetic resin sheet.

In order to deal with the above problems, Patent Documents 1 and 2 disclose a gas barrier sheet in which a flattening layer is formed on a synthetic resin sheet, and a gas barrier inorganic compound thin film is stacked on the flattening layer.

However, the gas barrier sheets disclosed in Patent Documents 1 and 2 have a problem in that interlayer adhesion between the flattening layer and the gas barrier layer or the inorganic material layer (electrode material layer) is poor, so that it is necessary to provide a functional thin film that improves interlayer adhesion between the layers. This increases the thickness of the resulting gas barrier sheet, and also increases the number of production steps.

Patent Document 3 discloses a method that produces a gas barrier film by forming a polysilazane film on at least one side of a film, and subjecting the polysilazane film to a plasma treatment. When using the method disclosed in Patent Document 3, however, a sufficient gas barrier capability cannot be obtained unless the thickness of the gas barrier layer is increased to a micrometer level. For example, Patent Document 3 states that a water vapor transmission rate of 0.50 $g/m^2$/day was obtained when the gas barrier layer had a thickness of 0.1 μm. WO 2010/067857 relates to a laminate comprising a gas barrier layer formed from a material including at least an oxygen atom, a carbon atom, and a silicon atom and an inorganic compound layer, the gas barrier layer having an oxygen atom content rate that gradually decreases and a carbon atom content rate that gradually increases from the surface to the depth direction. It is preferable that the surface layer part of the gas barrier layer have a silicon atom 2p electron binding energy peak position determined by X-ray photoelectron spectroscopy (XPS) of 102 to 104 eV.

RELATED-ART DOCUMENT

PATENT DOCUMENT

Patent Document 1: JP-A-2003-154596
Patent Document 2: JP-A-2006-264118 (US 2006/232735 A1)
Patent Document 3: JP-A-2007-237588

SUMMARY OF THE INVENTION

TECHNICAL PROBLEM

The invention was conceived in view of the above situation. An object of the invention is to provide a formed article that exhibits excellent interlayer adhesion and an excellent gas barrier capability, a method for producing the same, an electronic device member that includes the formed article, and an electronic device that includes the electronic device member.

SOLUTION TO PROBLEM

The inventors conducted extensive studies in order to achieve the above object. As a result, the inventors found that excellent interlayer adhesion and an excellent gas barrier capability are achieved by a formed article that sequentially includes a base layer, a primer layer, and a gas barrier layer, the primer layer being formed of a material that includes at least a carbon atom, an oxygen atom, and a silicon atom, and is characterized in that the peak position of the binding energy of the 2p electrons of the silicon atom as determined by X-ray photoelectron spectroscopy (XPS) is 101.9 to 104 eV, and the gas barrier layer being a layer obtained by implanting ions into a polymer layer that includes at least one

compound selected from a group consisting of a polysilazane compound, a polyorganosiloxane compound, a polycarbosilane compound, and a polysilane compound, or the gas barrier layer being formed of a material that includes at least an oxygen atom and a silicon atom, a surface layer part of the gas barrier layer having an oxygen atom content rate of 60 to 75%, a nitrogen atom content rate of 0 to 10%, and a silicon atom content rate of 25 to 35%, based on the total content rate of oxygen atoms, nitrogen atoms, and silicon atoms, and the surface layer part of the gas barrier layer having a film density of 2.4 to 4.0 g/cm$^3$.

The inventors also found that such a formed article can be conveniently and efficiently produced by forming a primer layer on the surface of a base layer, the primer layer being formed of a material that includes at least a carbon atom, an oxygen atom, and a silicon atom, and being obtained by implanting ions into a polysilazane compound-containing layer, and is characterized in that the peak position of the binding energy of the 2p electrons of the silicon atom as determined by X-ray photoelectron spectroscopy (XPS) is 101.9 to 104 ev, forming a polymer layer on the primer layer, the polymer layer including at least one compound selected from the group consisting of a polysilazane compound, a polyorganosiloxane compound, a polycarbosilane compound, and a polysilane compound, and implanting ions into the surface area of the polymer layer.

Several aspects of the invention provides the following formed article (see (1) to (8)), method for producing a formed article (see (9) to (11)), electronic device member (see (12)), and electronic device (see (13)).

(1) A formed article sequentially including a base layer, a primer layer, and a gas barrier layer,
the primer layer being formed of a material that includes at least a carbon atom, an oxygen atom, and a silicon atom, and is characterized in that a peak position of binding energy of 2p electrons of the silicon atom as determined by X-ray photoelectron spectroscopy (XPS) is 101.9
to 104 eV, and the gas barrier layer being a layer obtained by implanting ions into a polymer layer that includes at least one compound selected from a group consisting of a polysilazane compound, a polyorganosiloxane compound, a polycarbosilane compound, and a polysilane compound.
(2) A formed article sequentially including a base layer, a primer layer that includes a silicon-containing compound, and a gas barrier layer,
the primer layer being formed of a material that includes at least a carbon atom, an oxygen atom, and a silicon atom, and is characterized in that a peak position of binding energy of 2p electrons of the silicon atom as determined by X-ray photoelectron spectroscopy (XPS) is 101.9 to 104 eV, the gas barrier layer being formed of a material that includes at least an oxygen atom and a silicon atom, a surface layer part of the gas barrier layer having an oxygen atom content rate of 60 to 75%, a nitrogen atom content rate of 0 to 10%, and a silicon atom content rate of 25 to 35%, based on a total content rate of oxygen atoms, nitrogen atoms, and silicon atoms, and being obtained by implanting ions into a polysilazane compound-containing layer, and the surface layer part of the gas barrier layer having a film density of 2.4 to 4.0 g/cm$^3$.
(4) The formed article according to (1) or (2), wherein an area of the primer layer up to a depth of 10 nm from an interface with the gas barrier layer has a carbon atom content rate of 5.0 to 65.0%, an oxygen atom content rate of 25.0 to 70.0%, and a silicon atom content rate of 3.0 to 30.0%, based on a total content rate of carbon atoms, oxygen atoms, and silicon atoms.
(5) The formed article according to (1) or (2), wherein the polysilazane compound is perhydropolysilazane.
(6) The formed article according to (1) or (2), wherein the ions are obtained by ionizing at least one gas selected from a group consisting of hydrogen, nitrogen, oxygen, argon, helium, neon, xenon, and krypton.
(7) The formed article according to (1) or (2), wherein the ions are implanted by a plasma ion implantation method.
(8) The formed article according to (1) or (2), the formed article having a water vapor transmission rate at a temperature of 40°C and a relative humidity of 90% of less than 0.50 g/m$^2$/day.
(9) A method for forming the formed article according to (1), the method including: forming a primer layer on a base layer, the primer layer being formed of a material that includes at least a carbon atom, an oxygen atom, and a silicon atom, and is characterized in that a peak position of binding energy of 2p electrons of the silicon atom as determined by X-ray photoelectron spectroscopy (XPS) is 101.9 to 104 eV; forming a polymer layer on the primer layer, the polymer layer including at least one compound selected from a group consisting of a polysilazane compound, a polyorganosiloxane compound, a polycarbosilane compound, and a polysilane compound; and implanting ions into a surface area of the polymer layer to form a gas barrier layer.
(10) The method according to (9), wherein the implanting includes implanting ions of at least one gas selected from a group consisting of hydrogen, nitrogen, oxygen, argon, helium, neon, xenon, and krypton.
(11) The method according to (9), wherein the implanting includes implanting the ions by a plasma ion implantation method.
(12) An electronic device member including the formed article according to (1) or (2).
(13) An electronic device including the electronic device member according to (12).

ADVANTAGEOUS EFFECTS OF THE INVENTION

The formed article according to the aspects of the invention exhibits excellent interlayer adhesion and an excellent gas barrier capability. The formed article also exhibit excellent transparency in addition to excellent interlayer adhesion and an excellent gas barrier capability. Therefore, the formed article may suitably be used as an electronic device (e.g., solar cell) member (e.g., solar cell backsheet).

The method according to the aspect of the invention can easily and efficiently produce the formed article according to the aspect of the invention that exhibits excellent interlayer adhesion and an excellent gas barrier capability. The method can also easily achieve an increase in area of the formed article at low cost as compared with the case of forming an inorganic film.

Since the electronic device member according to the aspect of the invention exhibits excellent interlayer adhesion and an excellent gas barrier capability, the electronic device member may suitably be used for an electronic device (e.g., touch panel, electronic paper, flexible display (e.g., organic/inorganic EL display), and solar cell).

DESCRIPTION OF EMBODIMENTS

A formed article, a method for producing a formed article, an electronic device member, and an electronic device according to the embodiments of the invention are described in detail bellow.

1) Formed article

A formed article according to one embodiment of the invention sequentially includes a base layer, a primer layer, and a gas barrier layer, the primer layer being formed of a material that includes at least a carbon atom, an oxygen atom, and a silicon atom, and is characterized in that the peak position of the binding energy of the 2p electrons of the silicon atom as determined by X-ray photoelectron spectroscopy (XPS) is 101.9 to 104 eV, and the gas barrier layer being a layer obtained by implanting ions into a polymer layer that includes at least one compound selected from a group consisting of a polysilazane compound, a polyorganosiloxane compound, a polycarbosilane compound, and a polysilane compound, or the gas barrier layer being formed of a material that includes at least an oxygen atom and a silicon atom, a surface layer part of the gas barrier layer having an oxygen atom content rate of 60 to 75%, a nitrogen atom content rate of 0 to 10%, and a silicon atom content rate of 25 to 35%, based on the total content rate of oxygen atoms, nitrogen atoms, and silicon atoms, and being obtained by implanting ions into a polysilazane compound-containing layer, and the surface layer part of the gas barrier layer having a film density of 2.4 to 4.0 g/cm$^3$.

Base layer

The formed article according to one embodiment of the invention includes the base layer. A material for forming the base layer is not particularly limited as long as the material is suitable for the intended use of the formed article. Examples of the material for forming the base layer include synthetic resins such as polyimides, polyamides, polyamideimides, polyphenylene ethers, polyetherketones, polyether ether ketones, polyolefins, polyesters, polycarbonates, polysulfones, polyether sulfones, polyphenylene sulfides, polyallylates, acrylic resins, cycloolefin polymers, and aromatic polymers.

Among these, polyesters, polyamides, polysulfones, polyether sulfones, polyphenylene sulfides, polyallylates, and cycloolefin polymers are preferable due to excellent transparency and versatility. It is more preferable to use polyesters or cycloolefin polymers.

Examples of the polyesters include polyethylene terephthalate, polybuthylene terephthalate, polyethylene naphthalate, polyallylates, and the like.

Examples of the polyamides include wholly aromatic polyamides, nylon 6, nylon 66, nylon copolymers, and the like.

Examples of the cycloolefin polymers include norbornene polymers, monocyclic olefin polymers, cyclic conjugated diene polymers, vinyl alicyclic hydrocarbon polymers, and hydrogenated products thereof. Specific examples of the cycloolefin polymers include APEL (ethylene-cycloolefin copolymer manufactured by Mitsui Chemicals Inc.), ARTON (norbornene polymer manufactured by JSR Corporation), ZEONOR (norbornene polymer manufactured by Zeon Corporation), and the like.

The thickness of the base layer is not particularly limited, and may be determined depending on the intended use of the formed article. The thickness of the base layer is normally 0.5 to 500 μm, and preferably 1 to 100 μm.

Primer layer

The formed article according to one embodiment of the invention includes the primer layer between the base layer and the gas barrier layer (described later). The primer layer is formed of a material that includes at least a carbon atom, an oxygen atom, and a silicon atom, and is characterized in that the peak position of the binding energy of the 2p electrons of the silicon atom as determined by X-ray photoelectron spectroscopy (XPS) is 101.9 to 104 eV, preferably 101.9 to 102.5 eV, and more preferably 102.0 to 102.3 eV.

The primer layer improves interlayer adhesion between the base layer and the gas barrier layer.

The peak position of the binding energy of the 2p electrons of the silicon atom differs (changes) depending on an atom that is bonded to the silicon atom. The peak position tends to increase when the silicon atom is bonded to an atom that has high electronegativity (e.g., oxygen atom). A silicon atom that is bonded to an oxygen atom improves adhesion to the gas barrier layer that includes a silicon compound.

When the peak position is high, adhesion to the gas barrier layer is improved, but adhesion to the base layer decreases. When the peak position is low, adhesion to the base layer is improved, but adhesion to the gas barrier layer decreases.

When the peak position of the binding energy of the 2p electrons of the silicon atom is within the above range, adhesion to the gas barrier layer and the base layer is improved, so that interlayer adhesion between the base layer and the gas barrier layer can be improved.

Note that the peak position of the binding energy of the 2p electrons of the silicon atom is measured by the method described in connection with the examples.

It is preferable that an area of the primer layer up to a depth of 10 nm from the interface with the gas barrier layer have a carbon atom content rate of 5.0 to 65.0%, an oxygen atom content rate of 25.0 to 70.0%, and a silicon atom content rate of 3.0 to 30.0%, based on the total content rate of carbon atoms, oxygen atoms, and silicon atoms.

It is more preferable that the carbon atom content rate be 10 to 35%, the oxygen atom content rate be 40 to 65%, and the silicon atom content rate be 22 to 25%, and it is particularly preferable that the carbon atom content rate be 10 to 16%, the oxygen atom content rate be 60 to 65%, and the silicon atom content rate be 23 to 25%.

Examples of the material for forming the primer layer include a hydrolyzate of a silane compound that includes at least a silicon atom, a carbon atom, and an oxygen atom, an organic resin (binder resin) that includes the hydrolyzate, and the like (hereinafter may be collectively referred to as "silicon-containing compound").

The content of the silicon-containing compound in the primer layer is preferably 50 wt% or more, and more preferably 90 wt% or more.

When the primer layer includes the silicon-containing compound, the primer layer rarely allows ions to pass through, and ions that have passed through the polymer layer do not reach the base layer when implanting ions into the polymer layer that includes one or more compounds selected from the group consisting of a polysilazane compound, a polyorganosiloxane compound, a polycarbosilane compound, and a polysilane compound. This makes it possible to prevent a situation in which ions reach the base layer, whereby the resin that forms the base layer would be carbonized and colored (i.e., transparency is impaired).

Note that the primer layer does not impair the transparency of the formed article since the primer layer is not carbonized and colored.

The carbon atom content rate, the oxygen atom content rate, and the silicon atom content rate are determined by elemental analysis using X-ray photoelectron spectroscopy (XPS).

Specific examples of the silicon-containing compound include a silane compound that includes at least a silicon atom, a carbon atom, and an oxygen atom, a hydrolyzate of the silane compound, and an organic resin (binder resin) that includes a silica sol.

A known compound may be used as the silane compound that includes at least a silicon atom, a carbon atom, and an oxygen atom. Examples of the silane compound that includes at least a silicon atom, a carbon atom, and an oxygen atom include trifunctional silane compounds such as methyltrimethoxysilane, phenyltrimethoxysilane, 3-methacryloxypropyltriethoxysilane, 3-glycidoxypropyltriethoxysilane, 3-aminopropyltrimethoxysilane, vinyltrimethoxysilane, 3-glycidoxypropyltrimethoxysilane, 2-(3,4-epoxycyclohexyl)ethyltrimethoxysilane, 3-glycidoxypropyltriethoxysilane, 3-acryloxyprophyltrimethoxysilane, 3-isocyanatopropyltriethoxysilane, 3-mercaptopropyltrimethoxysilane, vinyltriethoxysilane, vinyltrimethoxysilane, γ-methacryloxpropyltrimethoxysilane, N-(2-aminoethyl)-3-aminopropyltrimethoxysilane, γ-aminopropyltriethoxysilane, γ-mercaptopropyltrimethoxysilane, and 3-chloropropyltrimethoxysilane; bifunctional silane compounds such as dimethyldimethoxysilane, dimethyldiethoxysilane, vinylmethyldiethoxysilane, γ-glycidoxypropylmethyldiethoxysilane, 3-mercaptopropylmethyldimethoxysilane, and N-(2-aminoethyl)-3-aminopropylmethyldimethoxysilane; a combination of a tetrafunctional silane compound (e.g., tetramethoxysilane, tetraethoxysilane, or tetrabutoxysilane) with a trifunctional silane compound or a bifunctional silane compound; and the like. These silane compounds may be used either alone or in combination.

The hydrolyzate of the silane compound (hereinafter may be referred to as "silica sol") may be obtained by a

sol-gel method using the silane compound as a starting material. The sol-gel method subjects a solvent solution (sol) of at least one silane compound to hydrolysis and polycondensation in the presence of an acid or base catalyst to obtain a gel. Examples of the acid catalyst include hydrochloric acid, nitric acid, sulfuric acid, phosphoric acid, and the like. Examples of the base catalyst include triethylamine, pyridine, and the like. It is preferable to use the acid catalyst. The end of the silica sol may or may not be modified with an amino group or the like.

Examples of the organic resin (binder resin) to which the silica sol is added include polyurethane acrylate resins, polyester resins, polyethylene resins, and the like.

The silica sol is preferably added in an amount of about 20 to about 80 wt%, and more preferably 50 to 70 wt%, based on the total amount of the silica sol and the organic resin.

The primer layer may be formed by dissolving or dispersing at least one silicon-containing compound in an appropriate solvent to prepare a primer layer-forming solution, applying the primer layer-forming solution to the base layer, drying the resulting film, and optionally heating and/or irradiating the dried film.

Examples of the solvent include ester solvents such as ethyl acetate and propyl acetate; ketone solvents such as acetone and methyl ethyl ketone; aromatic hydrocarbon solvents such as benzene and toluene; saturated hydrocarbon solvents such as pentane and hexane; mixed solvents of two or more of these solvents; and the like.

A commercially available product may be used directly as the primer layer-forming solution. For example, a sol-gel coating liquid containing ethyl silicate as the main component ("Colcoat PX" manufactured by Colcoat Co., Ltd.) or the like may be used as the primer layer-forming solution.

The primer layer-forming solution may be applied to the base layer by a normal wet coating method. Examples of the wet coating method include dipping, roll coating, gravure coating, knife coating, air knife coating, roll knife coating, die coating, screen printing, spray coating, a gravure offset method, and the like.

The film formed by applying the primer layer-forming solution may be dried by hot-air drying, heat roll drying, infrared irradiation, or the like.

When the silicon-containing compound is a hydrolyzate of a silane compound that includes a polymerizable group such as a methacryloxy group, a photoinitiator may be added to a solution containing the silicon-containing compound to prepare a primer layer-forming solution, and a film may be formed using the primer layer-forming solution, and cured by applying light (ultraviolet rays) using a known method.

The photoinitiator is not particularly limited. A known compound may be used as the photoinitiator. Examples of the photoinitiator include 2,4,6-trimethylbenzoyldiphenylphosphine oxide, benzoin, benzoin methyl ether, benzoin ethyl ether, benzoin isopropyl ether, benzoin n-butyl ether, benzoin isobutyl ether, acetophenone, dimethylaminoacetophenone, 2,2-dimethoxy-2-phenylacetophenone, 2,2-diethoxy-2-phenylacetophenone, 2-hydroxy-2-methyl-1-phenylpropan-1-one, 1-hydroxycyclohcxyl phenyl ketone, 2-methyl-1-[4-(methylthio)phenyl]-2-morpholinopropan-1-one, 4-(2-hydroxyethoxy)phenyl 2-(hydroxyl-2-propyl) ketone, benzophenone, p-phenylbenzophenone, 4,4'-diethylaminobenzophenone, dichlorobenzophenone, 2-methylanthraquinone, 2-ethylanthraquinone, 2-t-butylanthraquinone, 2-aminoanthraquinone, 2-methylthioxanthone, 2-ethylthioxanethone, 2-chlorothioxanthone, 2,4-dimethylthioxanethone, 2,4-diethylthioxanthone, benzyl dimethyl ketal, acetophenone dimethyl ketal, p-dimethylaminobenzoates, oligo[2-hydroxy-2-methyl-1[4-(1-methylvinyl)phenyl]propanone], and the like.

The primer layer thus obtained exhibits excellent transparency, and exhibits excellent adhesion (interlayer adhesion) to the gas barrier layer.

The thickness of the primer layer is normally 1 to 1000 nm, and preferably 5 to 100 nm.

Gas barrier layer

The formed article according to one embodiment of the invention includes the gas barrier layer that is provided on the primer layer formed on the base layer.

The gas barrier layer blocks gas such as air and water vapor (i.e., does not allow gas such as air and water vapor to pass through).

The gas barrier layer included in the formed article according to one embodiment of the invention is

(I) a layer obtained by implanting ions into a polymer layer that includes at least one compound selected from the group consisting of a polysilazane compound, a polyorganosiloxane compound, a polycarbosilane compound, and a polysilane compound (the gas barrier layer obtained by implanting ions hereinafter may be referred to as "ion-implanted layer".), or

(II) a layer that is formed of a material that includes at least an oxygen atom and a silicon atom, the surface layer part of the layer having an oxygen atom content rate of 60 to 75%, a nitrogen atom content rate of 0 to 10%, and a silicon atom content rate of 25 to 35%, based on the total content rate of oxygen atoms, nitrogen atoms, and silicon atoms, and having a film density of 2.4 to 4.0 g/cm$^3$.

Gas barrier layer (I)

The content of the polysilazane compound, the polyorganosiloxane compound, the polycarbosilane compound, and/or the polysilane compound (hereinafter may be referred to as "polymer compound") in the polymer layer used to obtain the gas barrier layer (I) is preferably 50 wt% or more, and more preferably 70 wt% or more, so that a gas barrier layer that exhibits an excellent gas barrier capability can be formed.

The polysilazane compound used in connection with the invention is a polymer that includes a repeating unit that includes an -Si-N- bond in its molecule. Specific examples of the polysilazane compound include a compound that includes a repeating unit represented by the following formula (1).

[Chemical Formula 1]

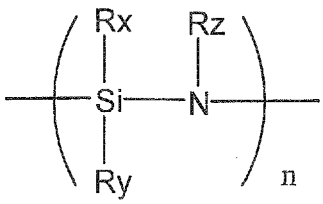

(1)

Note that n in the formula (1) is an arbitrary natural number.

Rx, Ry, and Rz independently represent a hydrogen atom or a non-hydrolyzable group such as a substituted or unsubstituted alkyl group, a substituted or unsubstituted cycloalkyl group, a substituted or unsubstituted alkenyl group, a substituted or unsubstituted aryl group, or an alkylsilyl group.

Examples of the unsubstituted alkyl group include alkyl groups having 1 to 10 carbon atoms (e.g., methyl group, ethyl group, n-propyl group, isopropyl group, n-butyl group, isobutyl group, sec-butyl group, t-butyl group, n-pentyl group, isopentyl group, neopentyl group, n-hexyl group, n-heptyl group, and n-octyl group).

Examples of the unsubstituted cycloalkyl group include cycloalkyl groups having 3 to 10 carbon atoms (e.g., cyclobutyl group, cyclopentyl group, cyclohexyl group, and cycloheptyl group).

Examples of the unsubstituted alkenyl group include alkenyl groups having 2 to 10 carbon atoms (e.g., vinyl group, 1-propenyl group, 2-propenyl group, 1-butenyl group, 2-butenyl group, and 3-butenyl group).

Examples of a substituent that may substitute the alkyl group, the cycloalkyl group, and the alkenyl group include halogen atoms such as a fluorine atom, a chlorine atom, a bromine atom, and an iodine atom; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

Examples of the unsubstituted aryl group include aryl groups having 6 to 10 carbon atoms (e.g., phenyl group, 1-naphthyl group, and 2-naphthyl group).

Examples of a substituent that may substitute the aryl group include halogen atoms such as a fluorine atom, a chlorine atom, a bromine atom, and an iodine atom; alkyl groups having 1 to 6 carbon atoms, such as a methyl group and an ethyl group; alkoxy groups having 1 to 6 carbon atoms, such as a methoxy group and an ethoxy group; a nitro group; a cyano group; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

Examples of the alkylsilyl group include a trimethylsilyl group, a triethylsilyl group, a triisopropylsilyl group, a tri-t-butylsilyl group, a methyldiethylsilyl group, a dimethylsilyl group, a diethylsilyl group, a methylsilyl group, an ethylsilyl group, and the like.

Among these, a hydrogen atom, an alkyl group having 1 to 6 carbon atoms, or a phenyl group is preferable as Rx, Ry, and Rz. A hydrogen atom is particularly preferable as Rx, Ry, and Rz.

The polysilazane compound that includes the repeating unit represented by the formula (1) may be an inorganic polysilazane in which Rx, Ry, and Rz represent a hydrogen atom, or an organic polysilazane in which at least one of Rx, Ry, and Rz does not represent a hydrogen atom.

Examples of the inorganic polysilazane include a perhydropolysilazane that has a linear structure that includes a repeating unit represented by the following formula, has a molecular weight of 690 to 2000, and includes three to ten $SiH_3$ groups in one molecule (see JP-B-63-16325),

[Chemical Formula 2]

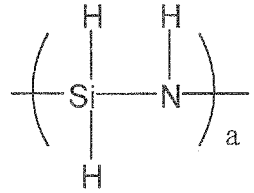

wherein a is an arbitrary natural number, a perhydropolysilazane that has a linear structure and a branched structure, and includes a repeating unit represented by the following formula (A),

[Chemical Formula 3]

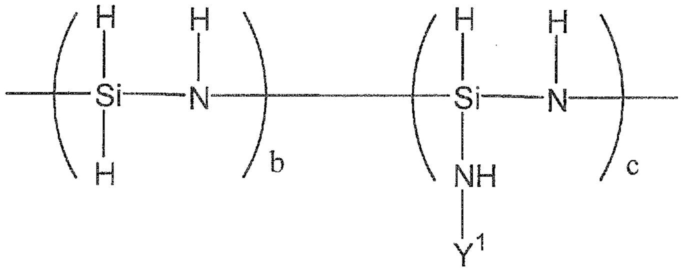
(A)

wherein b and c are arbitrary natural numbers, and $Y^1$ represents a hydrogen atom or a group represented by the following formula (B),

[Chemical Formula 4]

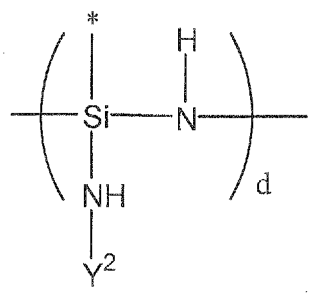
(B)

wherein d is an arbitrary natural number, * indicates the bonding position, and $Y^2$ represents a hydrogen atom or a group represented by the formula (B), a perhydropolysilazane that has a linear structure, a branched structure, and a cyclic structure in its molecule, and includes the perhydropolysilazane structure represented by the following formula (C),

[Chemical Formula 5]

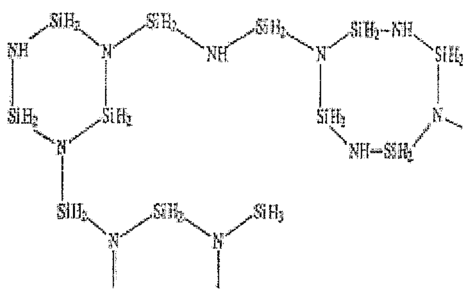
(C)

and the like.

Examples of the organic polysilazane include

(i) a polysilazane that includes a repeating unit represented by -(Rx'SiHNH)- (wherein Rx' represents a substituted or unsubstituted alkyl group, a substituted or unsubstituted cycloalkyl group, a substituted or unsubstituted alkenyl group, a substituted or unsubstituted aryl group, or an alkylsilyl group (hereinafter the same)), and has a cyclic structure having a degree of polymerization of 3 to 5,

(ii) a polysilazane that includes a repeating unit represented by -(Rx'SiHNRz')-(wherein Rz' represents a substituted or unsubstituted alkyl group, a substituted or unsubstituted cycloalkyl group, a substituted or unsubstituted alkenyl group, a substituted or unsubstituted aryl group, or an alkylsilyl group), and has a cyclic structure having a degree of polymerization of 3 to 5,

(iii) a polysilazane that includes a repeating unit represented by -(Rx'Ry'SiNH)-(wherein Ry' represents a substituted or unsubstituted alkyl group, a substituted or unsubstituted cycloalkyl group, a substituted or unsubstituted alkenyl group, a substituted or unsubstituted aryl group, or an alkylsilyl group), and has a cyclic structure having a degree of polymerization of 3 to 5,

(iv) a polyorgano(hydro)silazane that includes a structure represented by the following formula in its molecule,

[Chemical Formula 6]

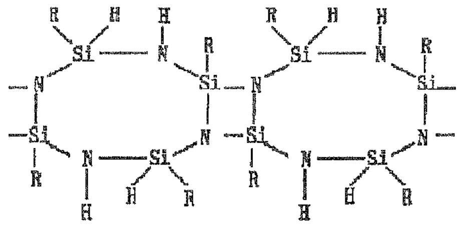

$R=CH_3$

(v) a polysilazane that includes a repeating unit represented by the following formula,

[Chemical Formula 7]

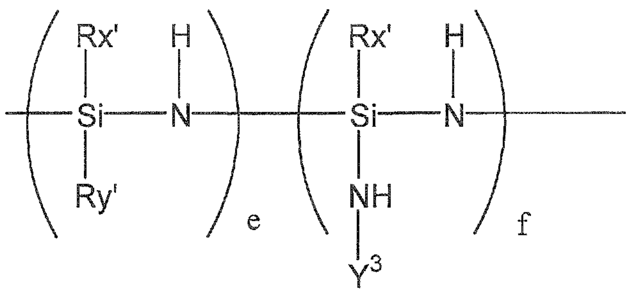

wherein Rx' and Ry' are the same as defined above, e and f are arbitrary natural numbers, and $Y^3$ represents a hydrogen atom or a group represented by the following formula (E),

[Chemical Formula 8]

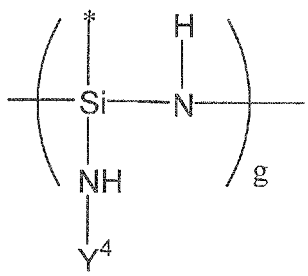

(E)

wherein g is an arbitrary natural number, * indicates the bonding position, and $Y^4$ represents a hydrogen atom or a group represented by the formula (E), and the like.

The above organic polysilazanes may be produced by a known method. For example, the above organic polysilazanes may be produced by reacting ammonia or a primary amine with a reaction product of a substituted or unsubstituted halogenosilane compound represented by the following formula (2) and a secondary amine.
[Chemical Formula 9]

$$R^1_{4-m}SiX_m \qquad (2)$$

wherein m is 2 or 3, X represents a halogen atom, and $R^1$ represents a substituent that substitutes Rx, Ry, Rz, Rx', Ry', or Rz'.

The secondary amine, ammonia, and the primary amine may be appropriately selected depending on the structure of the target polysilazane compound.

A modified polysilazane may also be used as the polysilazane compound. Examples of the modified polysilazane include a polymetallosilazane that includes a metal atom (which may be crosslinked), a polysiloxazane that includes a repeating unit represented by $(SiH_2)_g(NH)_h)$ and a repeating unit represented by $(SiH_2)_iO$ (wherein g, h, and i are 1, 2, or 3) (see JP-A62-195024), a polyborosilazane produced by reacting a polysilazane with a boron compound (see JP-A-2-84437), a polymetallosilazane produced by reacting a polysilazane with a metal alkoxide (see JP-A-63-81122, for example), an inorganic silazane polymer and a modified polysilazane (see JP-A-1-138108, for example), a copolymer silazane produced by introducing an organic component into a polysilazane (see JP-A-2-175726, for example), a low-temperature ceramic polysilazane obtained by adding a ceramic-forming catalyst compound to a polysilazane (see JP-A-5-238827, for example),
a silicon alkoxide-addition polysilazane (see JP-A-5-238827), a glycidol-addition polysilazane (see JP-A-6-122852), an acetylacetonato complex-addition polysilazane (see JP-A-6-306329), a metal carboxylate-addition polysilazane (see JP-A-6-299118, for example),
a polysilazane composition produced by adding an amine and/or an acid to the above polysilazane or modified polysilazane (see JP-A-9-31333), a modified polysilazane produced by adding an alcohol (e.g., methanol) or hexamethyldisilazane to the terminal nitrogen (N) atom of perhydropolysilazane (see JP-A-5-345826 and JP-A-4-63833), and the like.

The polysilazane compound used in connection with the invention is preferably an inorganic polysilazane in which Rx, Ry, and Rz represent hydrogen atoms, or an organic polysilazane in which at least one of Rx, Ry, and Rz does not represent a hydrogen atom, and more preferably an inorganic polysilazane from the viewpoint of availability and a capability to form an implanted layer that exhibits an excellent gas barrier capability.

The number average molecular weight of the polysilazane compound is not particularly limited, but is preferably 100 to 50,000.

A product commercially available as a glass coating material or the like may be used directly as the polysilazane compound.

The polysilazane layer may include an additional component in addition to the polysilazane compound as long as the object of the invention is not impaired. Examples of the additional component include a curing agent, an additional polymer, an aging preventive, a light stabilizer, a flame retardant, and the like.

The content of the polysilazane compound in the polysilazane layer is preferably 50 wt% or more, and more preferably 70 wt% or more, so that an ion-implanted layer that exhibits an excellent gas barrier capability can be formed.

The polysilazane layer may be formed by an arbitrary method. For example, the polysilazane layer may be formed by applying a layer-forming solution that includes at least one polysilazane compound, an optional additional component, a solvent, and the like to the primer layer, and appropriately drying the resulting film.

The polysilazane layer may also be formed by causing gas of a plasma-polymerizable silazane compound (e.g., dimethyldisilazane, tetramethyldisilazane, or hexamethyldisilazane) to come in contact with a plastic formed article, and subjecting the resulting product to plasma polymerization (see JP-A-9-143289).

The polyorganosiloxane compound is obtained by polycondensing a silane compound that includes a hydrolyzable functional group.

The main chain structure of the polyorganosiloxane compound is not particularly limited. The main chain structure of the polyorganosiloxane compound may be linear, ladder-like, or polyhedral.

Examples of the linear main chain structure of the polyorganosiloxane compound include a structure represented by the following formula (a). Examples of the ladder-like main chain structure of the polyorganosiloxane compound include a structure represented by the following formula (b). Examples of the polyhedral main chain structure of the polyorganosiloxane compound include a structure represented by the following formula (c).

[Chemical Formula 10]

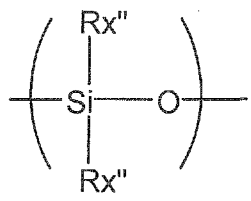

(a)

[Chemical Formula 11]

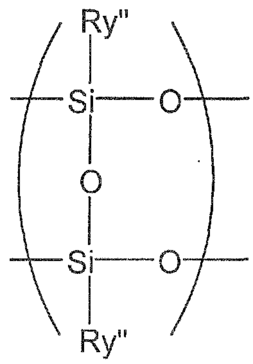

(b)

[Chemical Formula 12]

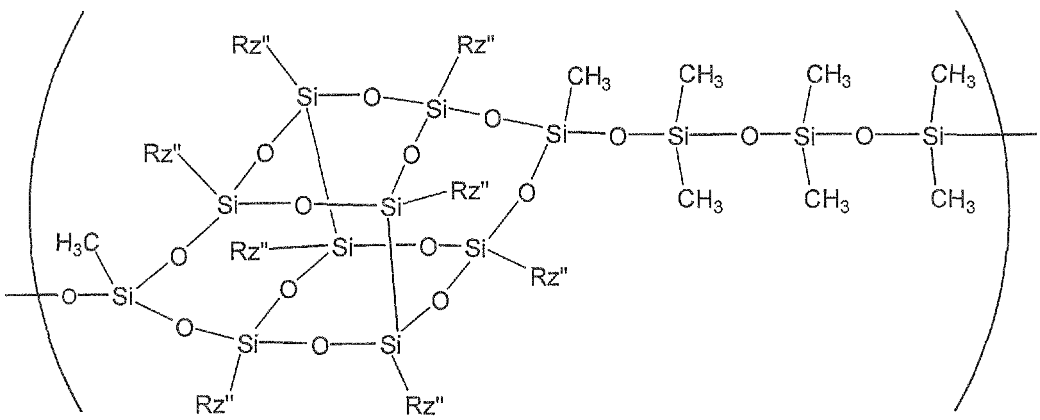

(c)

wherein Rx", Ry", and Rz" independently represent a hydrogen atom or a non-hydrolyzable group such as a substituted

or unsubstituted alkyl group, a substituted or unsubstituted alkenyl group, or a substituted or unsubstituted aryl group. Note that Rx" in the formula (a), Ry" in the formula (b), and Rz" in the formula (c) may respectively be either identical or different, provided that a case where both Rx" in the formula (a) represent a hydrogen atom is excluded.

Examples of the substituted or unsubstituted alkyl group include alkyl groups having 1 to 10 carbon atoms (e.g., methyl group, ethyl group, n-propyl group, isopropyl group, n-butyl group, isobutyl group, sec-butyl group, t-butyl group, n-pentyl group, isopentyl group, neopentyl group, n-hexyl group, n-heptyl group, and n-octyl group).

Examples of the alkenyl group include alkenyl groups having 2 to 10 carbon atoms (e.g., vinyl group, 1-propenyl group, 2-propenyl group, 1-butenyl group, 2-butenyl group, and 3-butenyl group).

Examples of a substituent that may substitute the alkyl group and the alkenyl group include halogen atoms such as a fluorine atom, a chlorine atom, a bromine atom, and an iodine atom; a hydroxyl group; a thiol radical; an epoxy group; a glycidoxy group; a (meth)acryloyloxy group; substituted or unsubstituted aryl groups such as a phenyl group, a 4-methylphenyl group, and a 4-chlorophenyl group; and the like.

Examples of the unsubstituted aryl group include aryl groups having 6 to 10 carbon atoms (e.g., phenyl group, 1-naphthyl group, and 2-naphthyl group).

Examples of a substituent that may substitute the aryl group include halogen atoms such as a fluorine atom, a chlorine atom, a bromine atom, and an iodine atom; alkyl groups having 1 to 6 carbon atoms, such as a methyl group and an ethyl group; alkoxy groups having 1 to 6 carbon atoms, such as a methoxy group and an ethoxy group; a nitro group; a cyano group; a hydroxyl group; a thiol group; an epoxy group; a glycidoxy group; a (meth)acryloyloxy group; substituted or unsubstituted aryl groups such as a phenyl group, a 4-methylphenyl group, and a 4-chlorophenyl group; and the like.

Among these, a hydrogen atom, an alkyl group having 1 to 6 carbon atoms, or a phenyl group is preferable, and an alkyl group having 1 to 6 carbon atoms is particularly preferable.

The polyorganosiloxane compound is preferably a linear compound represented by the formula (a), and more preferably a polydimethylsiloxane represented by the formula (a) in which both Rx represent a methyl group, from the viewpoint of availability and a capability to form a layer that exhibits an excellent gas barrier capability.

The polyorganosiloxane compound may be obtained by a known production method that polycondenses a silane compound that includes a hydrolyzable functional group, for example.

The silane compound may be appropriately selected depending on the structure of the target polyorganosiloxane compound. Specific examples of a preferable silane compound include bifunctional silane compounds such as dimethyldimethoxysilane, dimethyldiethoxysilane, diethyldimethoxysilane, and diethyldiethoxysilane; trifunctional silane compounds such as methyltrimethoxysilane, methyltriethoxysilane, ethyltrimethoxysilane, ethyltriethoxysilane, n-propyltrimethoxysilane, n-butyltriethoxysilane, phenyltrimethoxysilane, phenyltriethoxysilane, and phenyldiethoxymethoxysilane; tetrafunctional silane compounds such as tetramethoxysilane, tetraethoxysilane, tetra-n-propoxysilane, tetraisopropoxysilane, tetra-n-butoxysilane, tetra-t-butoxysilane, tetra-s-butoxysilane, methoxytriethoxysilane, dimethoxydiethoxysilane, and trimethoxyethoxysilane; and the like.

A product commercially available as a release agent, an adhesive, a sealant, a paint, or the like may be used directly as the polyorganosiloxane compound.

The term "polycarbosilane compound" used herein refers to a polymer compound that includes an -Si-C- bond in the main chain of the molecule. A compound that includes a repeating unit represented by the following formula (d) is preferable as the polycarbosilane compound.

[Chemical Formula 13]

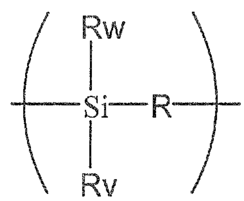

(d)

wherein Rw and Rv independently represent a hydrogen atom, a hydroxyl group, an alkyl group, an aryl group, an alkenyl group, or a monovalent heterocyclic group, provided that a plurality of Rw and a plurality of Rv may respectively be either identical or different.

Examples of the alkyl group, the aryl group, and the alkenyl group represented by Rw and Rv include those mentioned above in connection with Rx and the like.

The heterocyclic ring of the monovalent heterocyclic group is not particularly limited as long as the heterocyclic ring is derived from a 3 to 10-membered cyclic compound that includes a carbon atom and at least one heteroatom (e.g., oxygen atom, nitrogen atom, or sulfur atom).

Specific examples of the monovalent heterocyclic group include a 2-pyridyl group, a 3-pyridyl group, a 4-pyridyl group, a 2-thienyl group, a 3-thienyl group, a 2-furyl group, a 3-furyl group, a 3-pyrazolyl group, a 4-pyrazolyl group, a 2-imidazolyl group, a 4-imidazolyl group, a 1,2,4-triazin-3-yl group, a 1,2,4-triazin-5-yl group, a 2-pyrimidyl group, a 4-pyrimidyl group, a 5-pyrimidyl group, a 3-pyridazyl group, a 4-pyridazyl group, a 2-pyrazyl group, a 2-(1,3,5-triazyl) group, a 3-(1,2,4-triazyl) group, a 6-(1,2,4-triazyl) group, a 2-thiazolyl group, a 5-thiazolyl group, a 3-isothiazolyl group, a 5-isothiazolyl group, a 2-(1,3,4-thiadiazolyl) group, a 3-(1,2,4-thiadiazolyl) group, a 2-oxazolyl group, a 4-oxazolyl group, a 3-isoxazolyl group, a 5-isoxazolyl group, a 2-(1,3,4-oxadiazolyl) group, a 3-(1,2,4-oxadiazolyl) group, a 5-(1,2,3-oxadiazolyl) group, and the like.

These groups may be substituted with a substituent (e.g., alkyl group, aryl group, alkoxy group, or aryloxy group) at an arbitrary position.

R represents an alkylene group, an arylene group, or a divalent heterocyclic group.

Examples of the alkylene group represented by R include alkylene groups having 1 to 10 carbon atoms, such as a methylene group, an ethylene group, a propylene group, a trimethylene group, a tetramethylene group, a pentamethylene group, a hexamethylene group, and an octamethylene group.

Examples of the arylene group include arylene groups having 6 to 20 carbon atoms, such as a p-phenylene group, a 1,4-naphthylene group, and a 2,5-naphthylene group.

The divalent heterocyclic group is not particularly limited as long as the divalent heterocyclic group is a divalent group derived from a 3 to 10-membered cyclic compound that includes a carbon atom and at least one heteroatom (e.g., oxygen atom, nitrogen atom, or sulfur atom).

Specific examples of the divalent heterocyclic group include a thiophenediyl group such as a 2,5-thiophenediyl group; a furandiyl group such as a 2,5-furandiyl group; a selenophenediyl group such as a 2,5-selenophenediyl group; a pyrrolediyl group such as a 2,5-pyrrolediyl group; a pyridinediyl group such as a 2,5-pyridinediyl group and a 2,6-pyridinediyl group; a thienothiophenediyl group such as a 2,5-thieno[3,2-b]thiophenediyl group and a 2,5-thieno[2,3-b]thiophenediyl group; a quinolinediyl group such as a 2,6-quinolinediyl group; an isoquinolinediyl group such as a 1,4-isoquinolinediyl group and a 1,5-isoquinolinediyl group; a quinoxalinediyl group such as a 5,8-quinoxalinediyl group; a benzo[1,2,5]thiadiazolediyl group such as a 4,7-benzo[1,2,5]thiadiazolediyl group; a benzothiazolediyl group such as a 4,7-benzothiazolediyl group; a carbazolediyl group such as a 2,7-carbazolediyl group and a 3,6-carbazolediyl group; a phenoxazinediyl group such as a 3,7-phenoxazinediyl group; a phenothiazinediyl group such as a 3,7-phenothiazinediyl group; a dibenzosilolediyl group such as a 2,7-dibenzosilolediyl group; a benzodithiophenediyl group such as a 2,6-benzo[1,2-b:4,5-b']dithiophenediyl group, 2,6-benzo[1,2-b:5,4-b']dithiophenediyl group, 2,6-benzo[2,1-b:3,4-b']dithiophenediyl group, 2,6-benzo[1,2-b:3,4-b']dithiophenediyl group; and the like.

The alkylene group, the arylene group, and the divalent heterocyclic group represented by R may be substituted with a substituent (e.g., alkyl group, aryl group, alkoxy group, or halogen atom) at an arbitrary position.

It is preferable to use a polycarbosilane compound that includes the repeating unit represented by the formula (1) in which Rw and Rv independently represent a hydrogen atom, an alkyl group, or an aryl group, and R represents an alkylene group or an arylene group. It is more preferable to use a polycarbosilane compound that includes a repeating unit represented by the formula (1) in which Rw and Rv independently represent a hydrogen atom or an alkyl group, and R represents an alkylene group.

The weight average molecular weight of the polycarbosilane compound that includes the repeating unit represented by the formula (d) is normally 400 to 12,000.

The polycarbosilane compound may be produced by an arbitrary method. For example, the polycarbosilane compound may be produced a method that produces a polycarbosilane compound by thermal decomposition and polymerization of a polysilane (JP-A-51-126300), a method that produces a polycarbosilane compound by thermal rearrangement of poly(dimethylsilane) (Journal of Materials Science, 2569-2576, Vol. 13, 1978), a method that produces a polycarbosilane compound by a Grignard reaction of chloromethyltrichlorosilane (Organometallics, 1336-1344, Vol. 10, 1991), a method that produces a polycarbosilane compound by ring-opening polymerization of a disilacyclobutane (Journal of Organometallic Chemistry, 1-10, Vol. 521, 1996), a method that produces a polycarbosilane compound by reacting water and/or an alcohol with a raw material polymer that includes a dimethylcarbosilane structural unit and an SiH group-containing silane structural unit in the presence of a basic catalyst (JP-A-2006-117917), a method that produces a polycarbosilane compound by polymerizing a carbosilane that includes an organometallic group (e.g., trimethyltin) at the end using an organic main-group metal compound (e.g., n-butyllithium) as an initiator (JP-A-2001-328991), or the like.

The term "polysilane compound" used herein refers to a polymer compound that includes an -Si-Si- bond in its molecule. Examples of the polysilane compound include a compound that includes at least one repeating unit selected

from structural units represented by the following formula (e).

[Chemical Formula 14]

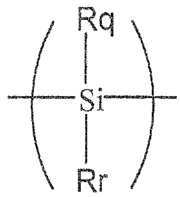

(e)

wherein Rq and Rr independently represent a hydrogen atom, an alkenyl group, a cycloalkyl group, a cycloalkenyl group, an aryl group, a hydroxyl group, an alkoxy group, a cycloalkyloxy group, an aryloxy group, an aralkyloxy group, a substituted or unsubstituted amino group, a silyl group, or a halogen atom.

Examples of the alkyl group, the alkenyl group, and the aryl group represented by Rq and Rr include those mentioned above in connection with Rx and the like.

Examples of the cycloalkyl group include cycloalkenyl groups having 3 to 10 carbon atoms, such as a cyclopentyl group, a cyclohexyl group, and a methylcyclohexyl group.

Examples of the cycloalkenyl group include cycloalkenyl groups having 4 to 10 carbon atoms, such as a cyclopentenyl group and a cyclohexenyl group.

Examples of the alkoxy group include alkoxy groups having 1 to 10 carbon atoms, such as a methoxy group, an ethoxy group, a propoxy group, an isopropoxy group, a butoxy group, a t-butoxy group, and a pentyloxy group.

Examples of the cycloalkyloxy group include cycloalkyloxy groups having 3 to 10 carbon atoms, such as a cyclopenthyloxy group and a cyclohexyloxy group.

Examples of the aryloxy group include aryloxy groups having 6 to 20 carbon atoms, such as a phenoxy group and a naphthyloxy group.

Examples of the aralkyloxy group include aralkyloxy groups having 7 to 20 carbon atoms, such as a benzyloxy group, a phenethyloxy group, and a phenylpropyloxy group.

Examples of the substituted or unsubstituted amino group include an amino group; N-monosubstituted or N,N-disubstituted amino groups substituted with an alkyl group, a cycloalkyl group, an aryl group, an aralkyl group, an acyl group, or the like; and the like.

Examples of the silyl group include $Si_{1-10}$ silanyl groups (preferably $Si_{1}$-$_{6}$ silanyl groups) such as a silyl group, a disilanyl group, and a trisilanyl group, substituted silyl groups (e.g., a substituted silyl group substituted with an alkyl group, a cycloalkyl group, an aryl group, an aralkyl group, an alkoxy group, or the like), and the like.

Examples of the halogen atom include a fluorine atom, a chlorine atom, a bromine atom, an iodine atom, and the like.

The cycloalkyl group, the cycloalkenyl group, the alkoxy group, the cycloalkyloxy group, the aryloxy group, the aralkyloxy group, and the silyl group may be substituted with a substituent (e.g., halogen atom, alkyl group, aryl group, or alkoxy group).

It is preferable to use a polysilane compound that includes the repeating unit represented by the formula (e), more preferably a polysilane compound that includes the repeating unit represented by the formula (e) in which Rq and Rr independently represent a hydrogen atom, a hydroxyl group, an alkyl group, an aryl group, an alkoxy group, an amino group, or a silyl group, and still more preferably a polysilane compound that includes the repeating unit represented by the formula (e) in which Rq and Rr independently represent a hydrogen atom, an alkyl group, or an aryl group, from the viewpoint of obtaining more advantageous effects.

The configuration of the polysilane compound is not particularly limited. The polysilane compound may be a homopolymer (e.g., noncyclic polysilane (e.g., linear polysilane, branched polysilane, or network polysilane) or cyclic polysilane), or may be a copolymer (e.g., random copolymer, block copolymer, alternating copolymer, or comb-like copolymer).

When the polysilane compound is a noncyclic polysilane, the end group (end substituent) of the polysilane compound may be a hydrogen atom, a halogen atom (e.g., chlorine atom), an alkyl group, a hydroxyl group, an alkoxy group, a silyl group, or the like.

Specific examples of the polysilane compound include homopolymers such as a polydialkylsilane such as polydimethylsilane, poly(methylpropylsilane), poly(methylbutylsilane), poly(methylpentylsilane), poly(dibutylsilane), and poly(dihexylsilane), a polydiarylsilane such as poly(diphenylsilane), and a poly(alkylarylsilane) such as poly(methylphenylsilane); copolymers such as a copolymer of a dialkylsilane and another dialkylsilane (e.g., dimethylsilane-methylhexylsilane copolymer), an arylsilane-alkylarylsilane copolymer (e.g., phenylsilane-methylphenylsilane copolymer), and a dialkylsilane-alkylarylsilane copolymer (e.g., dimethylsilane-methylphenylsilane copolymer, dimethylsilane-phenylhexylsilane copolymer, dimethylsilane-methylnaphthylsilane copolymer, and methylpropylsilane-methylphenylsilane copolymer); and the like.

The details of the polysilane compound are described in R. D. Miller and J. Michl, Chemical Review, Vol. 89, p. 1359 (1989), N. Matsumoto, Japanese Journal of Physics, Vol. 37, p. 5425 (1998), and the like. The polysilane compounds described in these documents may be used as the polysilane compound.

The average degree of polymerization (e.g., number average degree of polymerization) of the polysilane compound is normally 5 to 400, preferably 10 to 350, and more preferably about 20 to 300.

The weight average molecular weight of the polysilane compound is 300 to 100,000, preferably 400 to 50,000, and more preferably about 500 to 30,000.

A number of polysilane compounds are known in the art. The polysilane compound may be produced by a known method. For example, the polysilane compound may be produced by a method that subjects a halosilane to dehalogenation/polycondensation using magnesium as a reducing agent (magnesium reduction method, see WO98/29476, for example), a method that subjects a halosilane to dehalogenation/polycondensation in the presence of an alkali metal (Kipping method, see J. Am. Chem. Soc., 110, 124 (1988), Macromolecules, 23, 3423 (1990), for example), a method that subjects a halosilane to dehalogenation/polycondensation by electrode reduction (see J. Chem. Soc., Chem. Commun., 1161 (1990), J. Chem. Soc., Chem. Commun. 897 (1992), for example), a method that subjects a hydrosilane to dehydrogenation/condensation in the presence of a specific polymerization metal catalyst (see JP-A-4-334551, for example), a method that subjects a disilene crosslinked using a biphenyl or the like to anionic polymerization (see Macromolecules, 23, 4494 (1990), for example), a method that subjects a cyclic silane to ring-opening polymerization, or the like.

The polymer layer may include an additional component other than the above compound as long as the object of the invention is not impaired. Examples of the additional component include a curing agent, an additional polymer compound, an aging preventive, a light stabilizer, a flame retardant, and the like.

The polymer layer may be formed by an arbitrary method. For example, the polymer layer may be formed by applying a layer-forming solution that includes at least one polymer compound, an optional additional component, a solvent, and the like to the primer layer, and appropriately drying the resulting film.

A spin coater, a knife coater, a gravure coater, or the like may be used to apply the layer-forming solution.

It is preferable to heat the resulting film in order to dry the film, and improve the gas barrier capability of the film. In this case, the film is heated at 80 to 150°C for several tens of seconds to several tens of minutes.

The thickness of the polymer layer is not particularly limited, but is normally 20 to 1000 nm, preferably 30 to 500 nm, and more preferably 40 to 200 nm.

According to the embodiments of the invention, a film that exhibits a sufficient gas barrier capability can be obtained even if the polymer layer has a thickness at a nanometer level.

The gas barrier layer (I) is obtained by implanting ions into the polymer layer.

The dose of ions implanted into the polymer layer may be appropriately determined depending on the intended use of the resulting formed article (e.g., desired gas barrier capability and transparency), and the like.

Examples of the ions implanted into the polymer layer include ions of a rare gas such as argon, helium, neon, krypton, or xenon; ions of a fluorocarbon, hydrogen, nitrogen, oxygen, carbon dioxide, chlorine, fluorine, sulfur, or the like; ions of an alkane gas such as methane, ethane, propane, butane, pentane, or hexane; ions of an alkene gas such as ethylene, propylene, butene, or pentene; ions of an alkadiene gas such as pentadiene or butadiene; ions of an alkyne gas such as acetylene or methylacetylene; ions of an aromatic hydrocarbon gas such as benzene, toluene, xylene, indene, naphthalene, or phenanthrene; ions of a cycloalkane gas such as cyclopropane or cyclohexane; ions of a cycloalkene gas such as cyclopentene or cyclohexene; ions of a conductive metal such as gold, silver, copper, platinum, nickel, palladium, chromium, titanium, molybdenum, niobium, tantalum, tungsten, or aluminum; ions of silane ($SiH_4$) or an organosilicon compound; and the like.

Examples of the organosilicon compounds include tetraalkoxysilanes such as tetramethoxysilane, tetraethoxysilane, tetra-n-propoxysilane, tetraisopropoxysilane, tetra-n-butoxysilane, and tetra-t-butoxysilane; substituted or unsubstituted alkylalkoxysilanes such as dimethyldimethoxysilane, dimethyldiethoxysilane, diethyldimethoxysilane, methyltriethoxysilane, ethyltrimethoxysilane, and (3,3,3-trifluoropropyl)trimethoxysilane; arylalkoxysilanes such as diphenyldimethoxysilane and phenyltriethoxysilane; disiloxanes such as hexamethyldisiloxane (HMDSO); aminosilanes such as bis(dimethylamino)dimethylsilane, bis(dimethylamino)methylvinylsilane, bis(ethylamino)dimethylsilane, diethylaminotrimethylsilane, dimethylaminodimethylsilane, tetrakisdimethylaminosilane, and tris(dimethylamino)silane; silazanes such as hexamethyldisilazane, hexamethylcyclotrisilazane, heptamethyldisilazane, nonamethyltrisilazane, octamethylcyclotetrasilazane, and tetramethyldisilazane; cyanatosilanes such as tetraisocyanatosilane; halogenosilanes such as triethoxyfluorosilane; alkenylsilanes such as diallyldimethylsilane and allyltrimethylsilane; substituted or unsubstituted alkylsilanes such as di-t-butylsilane, 1,3-disilabutane, bis(trimethylsilyl)methane, trimethylsilane, tetramethylsilane, tris(trimethylsilyl)methane, tris(trimethylsilyl)silane, and benzyltrimethylsilane; silylalkynes such as bis(trimethylsilyl)acetylene, trimethylsilylacetylene, and 1-(trimethylsilyl)-1-propyne; silylalkenes such as 1,4-bistrimethylsilyl-1,3-butadiyne

and cyclopentadienyltrimethylsilane; arylalkylsilanes such as phenyldimethylsilane and phenyltrimethylsilane; alkynylalkylsilanes such as propargyltrimethylsilane; alkenylalkylsilanes such as vinyltrimethylsilane; disilanes such as hexamethyldisilane; siloxanes such as octamethylcyclotetrasiloxane, tetramethylcyclotetrasiloxane, and hexamethylcyclotetrasiloxane; N,O-bis(trimethylsilyl)acetamide; bis(trimethylsilyl)carbodiimide; and the like.

These compounds (ions) may be used either alone or in combination.

It is preferable to use ions of at least one element selected from the group consisting of hydrogen, nitrogen, oxygen, argon, helium, neon, xenon, and krypton due to ease of implantation and a capability to form a gas barrier layer that exhibits a particularly excellent gas barrier capability.

The dose of ions implanted may be appropriately determined depending on the intended use of the resulting formed article (e.g., desired gas barrier capability and transparency), and the like.

The ions may be implanted by an arbitrary method. For example, the ions may be implanted by applying ions (ion beams) accelerated by an electric field, implanting ions present in plasma, or the like. It is preferable to use a plasma ion implantation method since a gas barrier formed article can be easily obtained.

The plasma ion implantation method may be implemented by generating plasma in an atmosphere containing a plasma-generating gas (e.g., rare gas), and implanting ions (cations) present in the plasma into the surface area of the layer that includes the silicon-containing compound by applying a negative high-voltage pulse to the polymer layer, for example.

The thickness of the ion implantation area may be controlled by adjusting the implantation conditions (e.g., type of ions, applied voltage, and implantation time), and may be determined depending on the thickness of the layer that includes the silicon-containing compound, the intended use of the formed article, and the like. The thickness of the ion implantation area is normally 10 to 1000 nm.

Whether or not the ions have been implanted may be determined by performing elemental analysis on the surface area up to a depth of about 10 nm using X-ray photoelectron spectroscopy (XPS).

Gas barrier layer (II)

The gas barrier layer (II) is a layer that is formed of a material that includes at least an oxygen atom and a silicon atom, the surface layer part of the layer having an oxygen atom content rate of 60 to 75% (preferably 60 to 72%, and more preferably 63 to 70%), a nitrogen atom content rate of 0 to 10% (preferably 0.1 to 8%, and more preferably 0.1 to 6%), and a silicon atom content rate of 25 to 35% (preferably 27 to 35%, and more preferably 29 to 32%), based on the total content rate of oxygen atoms, nitrogen atoms, and silicon atoms, and having a film density of 2.4 to 4.0 g/cm$^3$.

The gas barrier layer (II) may be a layer obtained by implanting ions into a polysilazane compound-containing layer, for example.

The term "surface layer part" used herein in connection with the gas barrier layer refers to the surface of the gas barrier layer and an area of the gas barrier layer up to a depth of 5 nm from the surface of the gas barrier layer. The term "surface" used herein in connection with the gas barrier layer is intended to include the interface with another layer.

The oxygen atom content rate, the nitrogen atom content rate, and the silicon atom content rate in the surface layer part are measured by the method described in connection with the examples.

The film density may be calculated using X-ray reflectometry (XRR).

X-rays incident on a thin film formed on a substrate at a very low angle are totally reflected. When the incident angle of the X-rays is equal to or higher than the total reflection critical angle, the X-rays enter the thin film, and are divided into transmitted waves and reflected waves at the surface/interface of the thin film, and the reflected waves undergo interference. The film density can be determined by analyzing the total reflection critical angle. The thickness of the thin film may also be determined by performing measurement while changing the incident angle, and analyzing an interference signal of reflected waves due to a change in optical path difference.

The film density may be measured by the following method.

The refractive index n of a substance when applying X-rays, and the real part δ of the refractive index n are normally given by the following expressions (1) and (2).

[Expression 1]

$$n = 1 - \delta - i\beta \quad \cdots \quad (1)$$

[Expression 2]

$$\delta = \left(\frac{r_e \lambda^2}{2\pi}\right) N_0 \rho \sum_i x_i (Z_i + f_i') / \sum_i x_i M_i \quad \cdots \quad (2)$$

where, $r_e$ is the electron classical radius ($2.818 \times 10^{-15}$ m), $N_0$ is Avogadro's number, $\lambda$ is the wavelength of X-rays, $\rho$ is the film density (g/cm$^3$), Zi, Mi, and xi respectively are the atomic number, the atomic weight, and the atomic number ratio (molar ratio) of the ith atom, and fi' is the atomic scattering factor (abnormal dispersion term) of the atoms of the ith atom. The total reflection critical angle $\theta c$ is given by the following expression (3) when $\beta$ that relates to absorption is disregarded.
[Expression 3]

$$\theta \mathrm{c} = \sqrt{2\delta} \quad \cdots \quad (3)$$

Therefore, the film density $\rho$ is calculated by the following expression (4) based on the relationship between the expressions (2) and (3).
[Expression 4]

$$\rho = \frac{\theta \mathrm{c}^2 \sum_i x_i M_i}{\left(\frac{r_e \lambda^2}{\pi}\right) N_0 \sum_i x_i (Z_i + f_i')} \quad \cdots \quad (4)$$

The $\theta c$ can be calculated from the X-ray reflectivity. The $r_e$, No, and $\lambda$ are constants, and the Zi, Mi, and fi' are inherent to the constituent atom. A value obtained by XPS measurement is used as the atomic number ratio xi (molar ratio).
The film density of the surface layer part of the gas barrier layer is measured by the method described in connection with the examples, and is determined using the expression (4).
The thickness of the gas barrier layer is not particularly limited, but is normally 20 nm to 100 $\mu$m, preferably 30 to 500 nm, and more preferably 40 to 200 nm.
According to the embodiments of the invention, a formed article that exhibits a sufficient gas barrier capability can be obtained even if the gas barrier layer has a thickness at a nanometer level.
The formed article according to one embodiment of the invention includes the gas barrier layer that is formed on the base layer through the primer layer. The formed article may further include an additional layer. The additional layer may be a single layer, or may include a plurality of identical or different layers. Examples of the additional layer include an inorganic compound layer, a conductor layer, an impact-absorbing layer, and the like.
The inorganic compound layer is formed of (includes) one or more inorganic compounds. Examples of the inorganic compounds include inorganic compounds that can be deposited under vacuum, and exhibit a gas barrier capability, such as inorganic oxides, inorganic nitrides, inorganic carbides, inorganic sulfides, and composites thereof (e.g., inorganic oxynitride, inorganic oxycarbide, inorganic carbonitride, and inorganic oxycarbonitride).
The thickness of the inorganic compound layer is normally 10 to 1000 nm, preferably 20 to 500 nm, and more preferably 20 to 100 nm.
Examples of a material for forming the conductor layer include metals, alloys, metal oxides, electrically conductive compounds, mixtures thereof, and the like. Specific examples of the material for forming the conductor layer include antimony-doped tin oxide (ATO); fluorine-doped tin oxide (FTO); semiconductive metal oxides such as tin oxide, zinc oxide, indium oxide, indium tin oxide (ITO), and indium zinc oxide (IZO); metals such as gold, silver, chromium, and nickel; a mixture of a metal and a conductive metallic oxide; inorganic conductive substances such as copper iodide and copper sulfide; organic conductive materials such as polyaniline, polythiophene, and polypyrrole; and the like.
The conductor layer may be formed by an arbitrary method. For example, the conductor layer may be formed by evaporation (deposition), sputtering, ion plating, thermal CVD, plasma CVD, or the like.
The thickness of the conductor layer may be appropriately selected depending on the application and the like. The thickness of the conductor layer is normally 10 nm to 50 $\mu$m, and preferably 20 nm to 20 $\mu$m.
The impact-absorbing layer protects the gas barrier layer when an impact is applied to the gas barrier layer. A material for forming the impact-absorbing layer is not particularly limited. Examples of the material for forming the impact-absorbing layer include acrylic resins, urethane resins, silicone resins, olefin resins, rubber materials, and the like.

A product commercially available as a pressure-sensitive adhesive, a coating material, a sealing material, or the like may also be used as the material for forming the impact-absorbing layer. It is preferable to use a pressure-sensitive adhesive (e.g., acrylic pressure-sensitive adhesive, silicone pressure-sensitive adhesive, or rubber pressure-sensitive adhesive).

The impact-absorbing layer may be formed by an arbitrary method. For example, the impact-absorbing layer may be formed by applying an impact-absorbing layer-forming solution that includes the material (e.g., pressure-sensitive adhesive) for forming the impact-absorbing layer and an optional component (e.g., solvent) to the layer on which the impact-absorbing layer is to be formed, drying the resulting film, and optionally heating the dried film in the same manner as in the case of forming the layer that includes the silicon-containing compound.

Alternatively, the impact-absorbing layer may be formed on a release base, and transferred to the layer on which the impact-absorbing layer is to be formed.

The thickness of the impact-absorbing layer is normally 1 to 100 μm, and preferably 5 to 50 μm.

When the formed article according to one embodiment of the invention includes the additional layer, the additional layer may be situated at an arbitrary position as long as the primer layer and the gas barrier layer are adjacent to each other.

Note that the gas barrier layer may be formed on one side or each side of the base layer through the primer layer.

The formed article according to one embodiment of the invention exhibits excellent interlayer adhesion. For example, the formed article according to one embodiment of the invention exhibits excellent interlayer adhesion when subjected to a cross-cut adhesion test.

The formed article according to one embodiment of the invention exhibits an excellent gas barrier capability. The formed article according to one embodiment of the invention exhibits an excellent gas barrier capability since the formed article has a low water vapor transmission rate. For example, the formed article preferably has a water vapor transmission rate at a temperature of 40°C and a relative humidity of 90% of 0.5 $g/m^2$/day or less. The water vapor transmission rate of the formed article may be measured using a known gas transmission rate measurement system.

2) Method for producing formed article

A method for forming a formed article according to one embodiment of the invention includes forming a primer layer on a base layer, the primer layer being formed of a material that includes at least a carbon atom, an oxygen atom, and a silicon atom, and is characterized in that the peak position of the binding energy of the 2p electrons of the silicon atom as determined by X-ray photoelectron spectroscopy (XPS) is 101.5 to 104 eV, forming a polymer layer on the primer layer, the polymer layer including at least one compound selected from the group consisting of a polysilazane compound, a polyorganosiloxane compound, a polycarbosilane compound, and a polysilane compound, and implanting ions into the surface area of the polymer layer.

Whether or not the resulting formed article exhibits excellent transparency may be confirmed by measuring the total light transmittance of the formed article.

The total light transmittance of the formed article measured in accordance with JIS K 7361-1 is preferably 84% or more.

The primer layer may be formed on the base layer, and the polymer layer may be formed on the primer layer using an arbitrary method. It is preferable to form the primer layer on the base layer using the above method, and form the polymer layer on the resulting primer layer.

It is preferable to produce the formed article by implanting ions into the surface area of a polymer layer of a long formed body while feeding the formed body in a given direction, the formed body sequentially including a base layer, a primer layer that includes at least a carbon atom, an oxygen atom, and a silicon atom, and a polymer layer that includes at least one compound selected from the group consisting of a polysilazane compound, a polyorganosiloxane compound, a polycarbosilane compound, and a polysilane compound.

According to this method, ions can be implanted into a long formed body wound around a feed-out roll while feeding the formed body in a given direction, which can then be wound around a wind-up roll, for example. Therefore, an ion-implanted formed article can be continuously produced.

The long formed body may include an additional layer as long as the polymer layer is formed in the surface area. Examples of the additional layer include those mentioned above.

The thickness of the formed body is preferably 1 to 500 μm, and more preferably 5 to 300 μm, from the viewpoint of winding/unwinding operability and feeding operability.

Ions may be implanted into the polymer layer using an arbitrary method. It is preferable to implant the ions into the surface area of the polymer layer using a plasma ion implantation method.

The plasma ion implantation method includes applying a negative high-voltage pulse to the formed body that includes the polymer layer in its surface area and is exposed to plasma, to implant ions present in the plasma into the surface area of the polymer layer.

It is preferable to use (A) a plasma ion implantation method that implants ions present in plasma generated by utilizing an external electric field into the surface area of the polymer layer, or (B) a plasma ion implantation method that implants ions present in plasma generated due to an electric field produced by applying a negative high-voltage pulse to the polymer layer into the surface area of the polymer layer.

When using the method (A), it is preferable to set the ion implantation pressure (plasma ion implantation pressure) to 0.01 to 1 Pa. When the plasma ion implantation pressure is within the above range, a uniform ion-implanted layer can be formed conveniently and efficiently. This makes it possible to efficiently form an ion-implanted layer that exhibits transparency and a gas barrier capability.

The method (B) does not require increasing the degree of decompression, allows a simple operation, and significantly reduces the processing time. Moreover, the entire polymer layer can be uniformly treated, and ions present in the plasma can be continuously implanted into the surface area of the polymer layer with high energy when applying a negative high-voltage pulse. The method (B) also has an advantage in that ions can be uniformly implanted into the surface area of the polymer layer by merely applying a negative high-voltage pulse to the polymer layer without requiring a special means such as a high-frequency power supply (e.g., radio frequency (RF) power supply or microwave power supply).

When using the method (A) or (B), the pulse width when applying a negative high voltage pulse (i.e., during ion implantation) is preferably 1 to 15 $\mu$s. When the pulse width is within the above range, a transparent and uniform ion-implanted layer can be formed more conveniently and efficiently.

The voltage applied when generating plasma is preferably -1 to -50 kV, more preferably -1 to -30 kV, and particularly preferably -5 to -20 kV. If the applied voltage is higher than -1 kV, the dose may be insufficient, so that the desired performance may not be obtained. If the applied voltage is lower than -50 kV, the formed article may be electrically charged during ion implantation, or the formed article may be colored, for example.

The ion species used for plasma ion implantation is the same as described above. It is more preferable to use ions of hydrogen, nitrogen, oxygen, argon, helium, neon, xenon, or krypton due to ease of ion implantation and a capability to form a formed article that exhibits excellent transparency and an excellent gas barrier capability. It is more preferable to use ions of nitrogen, oxygen, argon, or helium.

A plasma ion implantation apparatus is used when implanting ions present in plasma into the surface area of the polymer layer.

Specific examples of the plasma ion implantation apparatus include ($\alpha$) a system that causes the polymer layer (hereinafter may be referred to as "ion implantation target layer") to be evenly enclosed by plasma by superimposing high-frequency electric power on a feed-through that applies a negative high-voltage pulse to the ion implantation target layer so that ions present in the plasma are attracted to and collide with the target, and thereby implanted and deposited therein (JP-A-2001-26887), ($\beta$) a system that includes an antenna in a chamber, wherein high-frequency electric power is applied to generate plasma, and positive and negative pulses are alternately applied to the ion implantation target layer after the plasma has reached an area around the ion implantation target layer, so that ions present in the plasma are attracted to and implanted into the target while heating the ion implantation target layer, causing electrons present in the plasma to be attracted to and collide with the target due to the positive pulse, and applying the negative pulse while controlling the temperature by controlling the pulse factor (JP-A-2001-156013), ($\gamma$) a plasma ion implantation apparatus that generates plasma using an external electric field utilizing a high-frequency electric power supply such as a microwave power supply, and causes ions present in the plasma to be attracted to and implanted into the target by applying a high-voltage pulse, ($\delta$) a plasma ion implantation apparatus that implants ions present in plasma generated due to an electric field produced by applying a high-voltage pulse without using an external electric field, and the like.

It is preferable to use the plasma ion implantation apparatus ($\gamma$) or ($\delta$) since the plasma ion implantation apparatus ($\gamma$) or ($\delta$) allows a simple operation, significantly reduces the processing time, and can be continuously used.

A method that utilizes the plasma ion implantation apparatus ($\gamma$) or ($\delta$) is described in WO2010/021326.

Since the plasma ion implantation apparatus ($\gamma$) or ($\delta$) is configured so that the high-voltage pulsed power supply also serves as a plasma generation means, a special means such as a high-frequency electric power supply (e.g., RF power supply or microwave power supply) is unnecessary. An ion-implanted layer can be continuously formed by implanting ions present in the plasma into the surface area of the polymer layer by merely applying a negative high-voltage pulse. Therefore, a formed article in which an ion-implanted layer is formed can be mass-produced.

3) Electronic device member and electronic device

An electronic device member according to one embodiment of the invention includes the formed article according to one embodiment of the invention. Therefore, since the electronic device member according to one embodiment of the invention exhibits an excellent gas barrier capability, a deterioration in an element (member or device) due to gas (e.g., water vapor) can be prevented. Since the electronic device member exhibits excellent light transmittance, the electronic device member may suitably be used as a display member for touch panels, liquid crystal displays, EL displays,

and the like; a solar cell backsheet; and the like.

An electronic device according to one embodiment of the invention includes the electronic device member according to one embodiment of the invention. Specific examples of the electronic device include a touch panel, a liquid crystal display, an organic EL display, an inorganic EL display, electronic paper, a solar cell, and the like.

Since the electronic device according to one embodiment of the invention includes the electronic device member that includes the formed article according to one embodiment of the invention, the electronic device exhibits an excellent gas barrier capability, interlayer adhesion, transparency.

EXAMPLES

The invention is further described below by way of examples. Note that the invention is not limited to the following examples.

The following X-ray photoelectron spectroscopy (XPS) measurement system, X-ray photoelectron spectroscopy (XPS) measurement conditions, X-ray reflectometry film density measurement method, plasma ion implantation apparatus, water vapor transmission rate measurement system, water vapor transmission rate measurement conditions, total light transmittance measurement system, and interlayer adhesion test method were used in the examples. Note that a system that implants ions using an external electric field was used as the plasma ion implantation apparatus.

Plasma ion implantation apparatus

RF power supply: "RF56000" manufactured by JEOL Ltd.
High-voltage pulse power supply: "PV-3-HSHV-0835" manufactured by Kurita Seisakusho Co., Ltd.

X-ray photoelectron spectrometer

Measurement system: "PHI Quantera SXM" manufactured by ULVAC-PHI, Incorporated

Measurement conditions

X-ray source: AlK$\alpha$
X-ray beam diameter: 100 $\mu$m
Electric power: 25 W
Voltage: 15 kV
Take-off angle: 45°
Degree of vacuum: $5.0\times10^{-8}$ Pa

The following measurements (1) to (3) were performed under the above measurement conditions.

(1) Measurement of implanted ions

The presence or absence of ions implanted into the plasma ion implantation target side of the formed article was confirmed by subjecting the surface area of the formed article up to a depth of about 10 nm to elemental analysis using an XPS system (manufactured by ULVAC-PHI, Incorporated).

(2) Measurement of primer layer

The gas barrier layer of the formed article was removed by sputtering under the following sputtering conditions to expose the interface of the primer layer with the gas barrier layer. The oxygen atom content rate, the carbon atom content rate, the silicon atom content rate, and the peak position of the binding energy of the 2p electrons of the silicon atom at the interface of the primer layer with the gas barrier layer were measured under the above measurement conditions.

Sputtering conditions

Sputtering gas: argon
Applied voltage: -4 kV

(3) Measurement of surface of base layer

In Comparative Examples 2 to 4 in which the primer layer was not provided, the oxygen atom content rate, the carbon atom content rate, and the silicon atom content rate in the surface area of the base layer up to a depth of 10 nm were measured.

X-ray photoelectron spectroscopy film density measurement method

The X-ray reflectance was measured under the following measurement conditions to determine the total reflection critical angle θc, and the film density of the surface area of the gas barrier layer was calculated from the total reflection critical angle θc.

The following measurement system and measurement conditions were used. Measurement system: X-ray diffractometer "SmartLab" (manufactured by Rigaku Corporation)

Measurement conditions

X-ray source: Cu-Kα1 (wavelength: 1.54059 Å)
Optical system: parallel beam optical system
Incident-side slit system: Ge(220)2 crystal, height-limiting slit: 5 mm, incident slit: 0.05 mm
Receiving-side slit system: receiving slit: 0.10 mm, soller slit: 5°
Detector: scintillation counter
Tube voltage-tube current: 45 kV-200 mA
Scan axis: 2θ/θ
Scan mode: continuous scan
Scan range: 0.1 to 3.0 deg.
Scan speed: 1 deg./min
Sampling interval: 0.002°/step

The oxygen atom content rate, the nitrogen atom content rate, and the silicon atom content rate in the surface layer part of the gas barrier layer measured by X-ray photoelectron spectroscopy were used for the atomic number ratio (xi).

Measurement of water vapor transmission rate

Water vapor transmission rate measurement system: "PERMATRAN-W3/33" manufactured by Mocon
Measurement conditions: relative humidity: 90%, temperature: 40°C

Measurement of total light transmittance of formed article

Total light transmittance measurement system: "NDH2000" manufactured by Nippon Denshoku Industries Co., Ltd.

The total light transmittance was measured in accordance with JI S K 7361-1.

Interlayer adhesion evaluation test

Separation of the film was measured in accordance with a cross-cut adhesion test (JIS K-5400 (1990)).

The presence or absence of separation of each square (film) was observed using a digital microscope to

determine the number of squares that were not separated. In Tables, "100/100" indicates that all of the 100 squares remained unseparated, "50/100" indicates that 50 squares among the 100 squares remained unseparated, and "0/100" indicates that all of the 100 squares were separated, for example.

Example 1

A composition containing a silicon-containing compound containing an acryloyl group as the main component ("AC-SQTA-100" manufactured by Toagosei Co., Ltd.) was dissolved in ethyl acetate, and 2,4,6-trimethylbenzoyldiphenylphosphine oxide ("Darocur TPO" manufactured by Ciba Specialty Chemicals Co., Ltd.) was added to the solution at a concentration of 3 mass% to prepare a primer layer-forming solution A.

The primer layer-forming solution A was applied to a polyethylene terephthalate film (PET film) ("PET25T-61M" manufactured by Toray Industries Inc., thickness: 25 μm) (base layer), and heated at 120°C for 1 minute. UV rays were applied to the primer layer-forming solution A (high-pressure mercury lamp, line speed: 20 m/min, integrated intensity: 100 mJ/$cm^2$, peak intensity 1.466 W, pass count: 2) using a UV-ray irradiation line to form a primer layer (thickness: 350 nm).

A silicone resin containing polydimethylsiloxane as the main component ("KS835" manufactured by Shin-Etsu Chemical Co., Ltd.) was applied to the primer layer, and heated at 120°C for 2 minutes to form a polymer layer (thickness: 100 nm) to obtain a formed body. Argon (Ar) ions were implanted into the surface of the polymer layer using the plasma ion implantation apparatus to obtain a formed article 1.

The plasma ion implantation conditions are shown below.

Gas flow rate: 100 sccm
Duty ratio: 0.5%
Repetition frequency: 1000 Hz
Applied voltage: -10 kV
RF power supply: frequency: 13.56 MHz, applied electric power: 1000 W
Chamber internal pressure: 0.2 Pa
Pulse width: 5 μs
Processing time (ion implantation time): 5 min
Line (feed) speed: 0.2 m/min

Example 2

1.90 g (12.5 mmol) of tetraethoxysilane ("Z-6697" manufactured by Dow Corning Toray Co., Ltd.) and 8.79 g (37.5 mmol) of 3-methacryloxypropyltriethoxysilane ("KBM-503" manufactured by Shin-Etsu Chemical Co., Ltd.) were dissolved in 50 ml of ethyl acetate. After the addition of 25 ml of distilled water, the components were mixed. After the addition of a few drops of phosphoric acid (catalyst) to the mixture, the mixture was stirred at room temperature for 18 hours. After the addition of a saturated sodium hydrogen carbonate aqueous solution to neutralize the reaction mixture, the organic layer was isolated preparatively. After drying the organic layer over anhydrous magnesium sulfate, ethyl acetate was evaporated under reduced pressure. The residue was added to a large quantity of n-hexane to obtain a precipitate. After dissolving the precipitate in ethyl acetate, 2,4,6-trimethylbenzoyldiphenylphosphine oxide ("Darocur TPO" manufactured by Ciba Specialty Chemicals Co., Ltd.) (photoinitiator) was added to the solution at a concentration of 3 mass% to prepare a primer layer-forming solution B.

A formed article 2 was obtained in the same manner as in Example 1, except that the primer layer-forming solution B was used instead of the primer layer-forming solution A.

Example 3

A primer layer-forming solution C was prepared in the same manner as in Example 2, except that the amount of tetraethoxysilane was changed from 1.90 g (12.5 mmol) to 3.81 g (25.0 mmol), and the amount of 3-methacryloxypropyltriethoxysilane was changed from 8.79 g (37.5 mmol) to 5.86 g (25.0 mmol).

A formed article 3 was obtained in the same manner as in Example 1, except that the primer layer-forming solution C was used instead of the primer layer-forming solution A.

Example 4

A primer layer-forming solution D was prepared in the same manner as in Example 2, except that the amount of tetraethoxysilane was changed from 1.90 g (12.5 mmol) to 5.71 g (37.5 mmol), and the amount of 3-methacryloxypropyltriethoxysilane was changed from 8.79 g (37.5 mmol) to 2.93 g (12.5 mmol).

A formed article 4 was obtained in the same manner as in Example 1, except that the primer layer-forming solution D was used instead of the primer layer-forming solution A.

Example 5

A primer layer-forming solution E was prepared in the same manner as in Example 2, except that 5.78 g (42.5 mmol) of trimethoxymethylsilane (manufactured by AZMAX) was used instead of 1.90 g (12.5 mmol) of tetraethoxysilane, and the amount of 3-methacryloxypropyltriethoxysilane was changed from 8.79 g (37.5 mmol) to 1.77 g (7.5 mmol).

A formed article 5 was obtained in the same manner as in Example 1, except that the primer layer-forming solution E was used instead of the primer layer-forming solution A.

Example 6

A primer layer-forming solution F was prepared in the same manner as in Example 2, except that 7.61g (50.0 mmol) of tetraethoxysilane was used instead of 1.90 g (12.5 mmol) of tetraethoxysilane and 8.79 g (37.5 mmol) of 3-methacryloxypropyltriethoxysilane, and 2,4,6-trimethylbenzoyldiphenylphosphine oxide was not added.

A formed article 6 was obtained in the same manner as in Example 1, except that the primer layer-forming solution F was used instead of the primer layer-forming solution A, and UV rays were not applied.

Example 7

A formed article 7 was obtained in the same manner as in Example 6, except that a sol-gel coating liquid containing ethyl silicate as the main component ("Colcoat PX" manufactured by Colcoat Co., Ltd.) (hereinafter referred to as "primer layer-forming solution G") was used instead of the primer layer-forming solution F.

Example 8

A formed article 8 was obtained in the same manner as in Example 1, except that a solution (solid content: 7.5 wt%) prepared by dissolving polycarbosilane ("NIPUSI Type S" manufactured by Nippon Carbon Co., Ltd.) in a toluene/methyl ethyl ketone mixed solvent (toluene:methyl ethyl ketone=7:3 (volume ratio (hereinafter the same)) was applied instead of the silicone resin containing polydimethylsiloxane as the main component, and heated at 120°C for 1 minute.

Example 9

A formed article 9 was obtained in the same manner as in Example 8, except that the primer layer-forming solution G was used instead of the primer layer-forming solution A.

Example 10

A formed article 10 was obtained in the same manner as in Example 1, except that a solution (solid content: 7 wt%) prepared by dissolving a polysilane ("OGSOL SI-10" manufactured by Osaka Gas Chemicals Co. Ltd.) in a toluene/methyl ethyl ketone mixed solvent (toluene:methyl ethyl ketone=7:3) was applied instead of the silicone resin containing polydimethylsiloxane as the main component, and heated at 120°C for 1 minute.

Example 11

A formed article 11 was obtained in the same manner as in Example 10, except that the primer layer-forming solution G was used instead of the primer layer-forming solution A.

Comparative Example 1

A formed article 1r was obtained in the same manner as in Example 1, except that a solution (solid content: 8 wt%) prepared by dissolving a resin containing a polyurethane acrylate UV-curable compound (i.e., a compound that does not include a silicon atom) as the main component ("Vylon UR1350" manufactured by Toyobo Co., Ltd.) in methyl ethyl ketone (hereinafter referred to as "primer layer-forming solution H") was used instead of the primer layer-forming solution A.

Comparative Example 2

A formed article was obtained in the same manner as in Example 1, except that the primer layer was not formed on the PET film. Specifically, a silicone resin layer was formed on the PET film, and argon ions were implanted into the surface of the silicone resin layer using the plasma ion implantation method to obtain a formed article 2r.

Comparative Example 3

A formed article was obtained in the same manner as in Example 8, except that the primer layer was not formed on the PET film. Specifically, a polycarbosilane layer was formed on the PET film, and argon ions were implanted into the surface of the polycarbosilane layer using the plasma ion implantation method to obtain a formed article 3r.

Comparative Example 4

A formed article was obtained in the same manner as in Example 10, except that the primer layer was not formed on the PET film. Specifically, a polysilane layer was formed on the PET film, and argon ions were implanted into the surface of the polysilane layer using the plasma ion implantation method to obtain a formed article 4r.

Comparative Example 5

A primer layer-forming solution (hereinafter referred to as "primer layer-forming solution I") was prepared in the same manner as in Example 6, except that 10.7 g (35.0 mmol) of triphenylethoxysilane, 1.49 g (10.0 mmol) of polydimethylsiloxane, and 0.69 g (5.0 mmol) of trimethoxymethylsilane were used instead of 7.61 g (50.0 mmol) of tetraethoxysilane.

A formed article 5r was obtained in the same manner as in Example 1, except that the primer layer-forming solution I was used instead of the primer layer-forming solution A.

In Examples 1 to 11 and Comparative Examples 1 to 4, implantation of ions was confirmed by subjecting the surface area of the formed article up to a depth of about 10 nm to elemental analysis using an XPS system (manufactured by ULVAC-PHI, Incorporated).

The carbon atom content rate, the oxygen atom content rate, the silicon atom content rate, and the binding energy in the surface area of the primer layer of each example and comparative example up to a depth of 10 nm from the interface with the gas barrier layer were measured. The measurement results are shown in Table 1.

In Comparative Examples 2 to 4 in which the primer layer was not provided, the carbon atom content rate, the oxygen atom content rate, and the silicon atom content rate in the surface area of the base layer up to a depth of 10 nm were 98.3%, 1.54%, and 0.16%, respectively.

TABLE 1

| | Formed article | Primer layer | | | | | Gas barrier layer |
|---|---|---|---|---|---|---|---|
| | | Type | Carbon atom (%) | Oxygen atom (%) | Silicon atom (%) | Binding energy (eV) | Main component |
| Example 1 | 1 | A | 60.3 | 32.0 | 7.7 | 101.921 | Polyorganosiloxane compound |
| Example 2 | 2 | B | 61.3 | 29.3 | 9.4 | 102.013 | Polyorganosiloxane compound |
| Example 3 | 3 | C | 58.5 | 31.1 | 10.4 | 102.124 | Polyorganosiloxane compound |
| Example 4 | 4 | D | 52.75 | 32.45 | 14.8 | 102.096 | Polyorganosiloxane compound |
| Examples 5 | 5 | E | 32.9 | 44.7 | 22.4 | 102.268 | Polyorganosiloxane compound |
| Example 6 | 6 | F | 11.85 | 63.4 | 24.6 | 103.213 | Polyorganosiloxane compound |

(continued)

| | Formed article | Primer layer | | | | | Gas barrier layer |
|---|---|---|---|---|---|---|---|
| | | Type | Carbon atom (%) | Oxygen atom (%) | Silicon atom (%) | Binding energy (eV) | Main component |
| Example 7 | 7 | G | 15.0 | 61.2 | 23.8 | 102.658 | Polyorganosiloxane compound |
| Example 8 | 8 | A | 60.3 | 32.0 | 7.7 | 101.921 | Polycarbosilane compound |
| Example 9 | 9 | G | 15.0 | 61.2 | 23.8 | 102.658 | Polycarbosilane compound |
| Example 10 | 10 | A | 60.3 | 32.0 | 7.7 | 101.921 | Polysilane compound |
| Example 11 | 11 | G | 15.0 | 61.2 | 23.8 | 102.658 | Polysilane compound |
| Comparative Example 1 | 1r | H | 69.3 | 30.64 | 0.06 | - | Polyorganosiloxane compound |
| Comparative Example 2 | 2r | - | | | | | Polyorganosiloxane compound |
| Comparative Example 3 | 3r | - | | | | | Polycarbosilane compound |
| Comparative Example 4 | 4r | - | | | | | Polysilane compound |
| Comparative Example 5 | 5r | I | 71.5 | 10.8 | 17.7 | 101.3 | Polyorganosiloxane compound |

The formed articles 1 to 11 obtained in Examples 1 to 11 and the formed articles 1r to 5r obtained in Comparative Examples 1 to 5 were subjected to the measurement of the water vapor transmission rate, and the interlayer adhesion test. The results are shown in Table 2.

TABLE 2

| | Formed article | Water vapor transmission rate (g/m$^2$/day) | Adhesion test |
|---|---|---|---|
| Example 1 | 1 | 0.30 | 100/100 |
| Example 2 | 2 | 0.25 | 100/100 |
| Example 3 | 3 | 0.33 | 100/100 |
| Example 4 | 4 | 0.25 | 100/100 |
| Example 5 | 5 | 0.21 | 100/100 |
| Example 6 | 6 | 0.24 | 50/100 |
| Example 7 | 7 | 0.29 | 25/100 |
| Example 8 | 8 | 0.15 | 100/100 |
| Example 9 | 9 | 0.10 | 33/100 |
| Example 10 | 10 | 0.25 | 75/100 |
| Example 11 | 11 | 0.23 | 10/100 |
| Comparative Example 1 | 1r | 0.33 | 0/100 |
| Comparative Example 2 | 2r | 0.23 | 0/100 |

(continued)

| | Formed article | Water vapor transmission rate (g/m$^2$/day) | Adhesion test |
|---|---|---|---|
| Comparative Example 3 | 3r | 0.13 | 0/100 |
| Comparative Example 4 | 4r | 0.24 | 0/100 |
| Comparative Example 5 | 5r | 0.35 | 0/100 |

As shown in Table 2, the formed articles 1 to 11 obtained in Examples 1 to 11 that contained the primer layer formed of the material containing a carbon atom, an oxygen atom, and a silicon atom, and characterized in that the peak position of the binding energy of the 2p electrons of the silicon atom was within the specific range, had a low water vapor transmission rate, and exhibited excellent interlayer adhesion.

Example 12

The primer layer-forming solution A was applied to a polyethylene terephthalate film (PET film) ("PET25T-61M" manufactured by Toray Industries Inc., thickness: 25 μm) (base layer), and heated at 120°C for 1 minute. UV rays were applied to the primer layer-forming solution A (high-pressure mercury lamp, line speed: 20 m/min, integrated intensity: 100 mJ/cm$^2$, peak intensity 1.466 W, pass count: 2) using a UV-ray irradiation line to form a primer layer (thickness: 350 nm).

A layer-forming solution containing perhydropolysilazane as the main component ("Aquamica NL110A-20" manufactured by Clariant Japan K.K.) ("gas barrier layer-forming solution A" in Table 3) was spin-coated onto the primer layer, and heated at 120°C for 2 minutes to form a polysilazane layer (thickness: 60 nm) to obtain a formed body. Argon (Ar) ions were implanted into the surface of the polysilazane layer in the same manner as in Example 1 using the plasma ion implantation apparatus to form a gas barrier layer to obtain a formed article 12.

Example 13

A formed article 13 was obtained in the same manner as in Example 12, except that the primer layer-forming solution B was used instead of the primer layer-forming solution A.

Example 14

A formed article 14 was obtained in the same manner as in Example 12, except that the primer layer-forming solution C was used instead of the primer layer-forming solution A.

Example 15

A formed article 25 was obtained in the same manner as in Example 12, except that the primer layer-forming solution D was used instead of the primer layer-forming solution A.

Example 16

A formed article 16 was obtained in the same manner as in Example 12, except that the primer layer-forming solution E was used instead of the primer layer-forming solution A.

Example 17

A formed article 12 was obtained in the same manner as in Example 12, except that the primer layer-forming solution F was used instead of the primer layer-forming solution A, and UV rays were not applied.

Example 18

A formed article 18 was obtained in the same manner as in Example 17, except that the primer layer-forming solution G was used instead of the primer layer-forming solution F.

Example 19

A formed article 19 was obtained in the same manner as in Example 12, except that the thickness of the polysilazane layer was changed to 150 nm.

Example 20

A formed article 20 was obtained in the same manner as in Example 12, except that the applied voltage during plasma ion implantation was changed to -5 kV.

Example 21

A formed article 21 was obtained in the same manner as in Example 12, except that the polysilazane layer was formed on the primer layer using a layer-forming solution containing methylpolysilazane as the main component ("tutu-Prom" manufactured by Clariant Japan K.K.) ("gas barrier layer-forming solution B" in Table 3).

Example 22

A formed article 22 was obtained in the same manner as in Example 12, except that nitrogen ($N_2$) was used as the plasma-generating gas instead of argon (Ar).

Example 23

A formed article 23 was obtained in the same manner as in Example 12, except that oxygen ($O_2$) was used as the plasma-generating gas instead of argon (Ar).

Example 24

A formed article 24 was obtained in the same manner as in Example 12, except that helium (He) was used as the plasma-generating gas instead of argon (Ar).

Example 25

A formed article 25 was obtained in the same manner as in Example 12, except that krypton (Kr) was used as the plasma-generating gas instead of argon (Ar).

Comparative Example 6

A formed article 6r was obtained in the same manner as in Example 12, except that a solution (solid content: 8 wt%) prepared by dissolving a resin containing a polyurethane acrylate UV-curable compound (i.e., a compound that does not include a silicon atom) as the main component ("Vylon UR1350" manufactured by Toyobo Co., Ltd.) in methyl ethyl ketone (hereinafter referred to as "primer layer-forming solution H") was used instead of the primer layer-forming solution A.

Comparative Example 7

A formed article was obtained in the same manner as in Example 12, except that the primer layer and the gas barrier layer were not formed on the PET film. Specifically, argon ions were implanted into the surface of the PET film using the plasma ion implantation method to obtain a formed article 7r.

Comparative Example 8

A formed article 8r was obtained in the same manner as in Example 12, except that the primer layer was not formed on the PET film.
In Examples 12 to 18 and Comparative Examples 6 and 7, implantation of ions was confirmed by subjecting the surface area of the formed article up to a depth of about 10 nm to elemental analysis using an XPS system (manufactured by ULVAC-PHI, Incorporated).
The primer layer-forming solution, the gas barrier layer-forming solution, the plasma-generating gas, the applied

voltage used in Examples 12 to 25 and Comparative Examples 6 to 8, the thickness of the primer layer, the thickness of the gas barrier layer, the carbon atom content rate, the oxygen atom content rate, the silicon atom content rate, and the binding energy (eV) in the surface area of the primer layer up to a depth of 10 nm from the interface with the gas barrier layer, and the oxygen atom content rate, the nitrogen atom content rate, the silicon atom content rate, and the film density in the surface layer part of the gas barrier layer are shown in Tables 3 to 5.

TABLE 3

| | Formed article | Primer layer-forming solution | Gas barrier layer-forming solution | Plasma-generating gas | Applied voltage (kV) |
|---|---|---|---|---|---|
| Example 12 | 12 | A | A | Ar | -10 |
| Example 13 | 13 | B | A | Ar | -10 |
| Example 14 | 14 | C | A | Ar | -10 |
| Example 15 | 15 | D | A | Ar | -10 |
| Example 16 | 16 | E | A | Ar | -10 |
| Example 17 | 17 | F | A | Ar | -10 |
| Example 18 | 18 | G | A | Ar | -10 |
| Example 19 | 19 | A | A | Ar | -10 |
| Example 20 | 20 | A | A | Ar | -5 |
| Example 21 | 21 | A | B | Ar | -10 |
| Example 22 | 22 | A | A | $N_2$ | -10 |
| Example 23 | 23 | A | A | $O_2$ | -10 |
| Example 24 | 24 | A | A | He | -10 |
| Example 25 | 25 | A | A | Kr | -10 |
| Comparative Example 6 | 6r | H | A | Ar | -10 |
| Comparative Example 7 | 7r | - | - | Ar | -10 |
| Comparative Example 8 | 8r | - | A | Ar | -10 |

TABLE 4

| | Primer layer | | | | |
|---|---|---|---|---|---|
| | Thickness (nm) | Area up to depth of 10 nm from interface with gas barrier layer | | | |
| | | Carbon atom (%) | Oxygen atom (%) | Silicon atom (%) | Binding energy (eV) |
| Example 12 | 350 | 60.3 | 32.0 | 7.7 | 101.921 |
| Example 13 | 350 | 61.3 | 29.3 | 9.4 | 102.013 |
| Example 14 | 350 | 58.5 | 31.1 | 10.4 | 102.124 |
| Example 15 | 350 | 52.75 | 32.45 | 14.8 | 102.096 |
| Example 16 | 350 | 32.9 | 44.7 | 22.4 | 102.268 |
| Example 17 | 350 | 11.9 | 63.4 | 24.6 | 103.213 |
| Example 18 | 350 | 15.0 | 61.2 | 23.8 | 102.658 |
| Example 19 | 350 | 11.9 | 63.4 | 24.6 | 101.921 |

(continued)

| | Primer layer | | | | |
|---|---|---|---|---|---|
| | Thickness (nm) | Area up to depth of 10 nm from interface with gas barrier layer | | | |
| | | Carbon atom (%) | Oxygen atom (%) | Silicon atom (%) | Binding energy (eV) |
| Example 20 | 350 | 11.9 | 63.4 | 24.6 | 101.921 |
| Example 21 | 350 | 11.9 | 63.4 | 24.6 | 101.921 |
| Example 22 | 350 | 11.9 | 63.4 | 24.6 | 101.921 |
| Example 23 | 350 | 11.9 | 63.4 | 24.6 | 101.921 |
| Example 24 | 350 | 11.9 | 63.4 | 24.6 | 101.921 |
| Example 25 | 350 | 11.9 | 63.4 | 24.6 | 101.921 |
| Comparative Example 6 | 350 | 69.3 | 30.64 | 0.06 | - |
| Comparative Example 7 | - | - | - | - | - |
| Comparative Example 8 | - | - | - | - | - |

TABLE 5

| | Gas barrier layer | | | | |
|---|---|---|---|---|---|
| | Thickness of polysilazane layer (nm) | Surface layer part | | | |
| | | Oxygen atom (%) | Nitrogen atom (%) | Silicon atom (%) | Film density |
| Example 12 | 60 | 63.00 | 7.42 | 29.58 | 2.63 |
| Example 13 | 60 | 62.89 | 7.39 | 29.81 | 2.65 |
| Example 14 | 60 | 63.31 | 7.10 | 29.59 | 2.60 |
| Example 15 | 60 | 62.10 | 7.23 | 30.67 | 2.55 |
| Example 16 | 60 | 62.00 | 7.49 | 30.51 | 2.52 |
| Example 17 | 60 | 63.55 | 7.31 | 29.14 | 2.55 |
| Example 18 | 60 | 61.95 | 7.52 | 30.53 | 2.61 |
| Example 19 | 150 | 63.11 | 5.35 | 31.54 | 3.57 |
| Example 20 | 60 | 67.21 | 2.51 | 30.28 | 2.72 |
| Example 21 | 60 | 60.21 | 5.11 | 34.68 | 2.52 |
| Example 22 | 60 | 70.10 | 1.35 | 28.55 | 3.29 |
| Example. 23 | 60 | 68.10 | 2.25 | 29.65 | 3.18 |
| Example 24 | 60 | 71.50 | 0.78 | 27.72 | 2.65 |
| Example 25 | 60 | 66.80 | 3.62 | 29.58 | 2.9 |
| Comparative Example 6 | 60 | 63.22 | 7.21 | 29.57 | 2.58 |
| Comparative Example 7 | - | - | - | - | - |
| Comparative Example 8 | 60 | 63.10 | 7.32 | 29.58 | 2.53 |

The total light transmittance and the water vapor transmission rate of the formed articles 12 to 25 obtained in Examples 12 to 25 and the formed articles 6r to 8r obtained in Comparative Examples 6 to 8 were measured.

In Examples 12 to 25 and Comparative Examples 6 to 8, the total light transmittance was measured in a state in which ions had been implanted into the surface of the primer layer formed on the base layer in order to determine coloration of the primer layer due to ion implantation. The measurement results are shown in Table 6.

TABLE 6

| | Formed article | Total light transmittance (%) primer layer/base layer | Total light transmittance (%) | Water vapor transmission rate ($g/m^2/day$) | Adhesion test |
|---|---|---|---|---|---|
| Example 12 | 1 | 84.9 | 84.5 | 0.052 | 100/100 |
| Example 13 | 2 | 85.1 | 84.8 | 0.050 | 100/100 |
| Example 14 | 3 | 86.5 | 86.2 | 0.054 | 100/100 |
| Examples 15 | 4 | 87.4 | 87.2 | 0.060 | 100/100 |
| Example 16 | 5 | 87.1 | 86.9 | 0.052 | 100/100 |
| Example 17 | 6 | 91.3 | 90.0 | 0.050 | 100/100 |
| Example 18 | 7 | 91.2 | 90.1 | 0.052 | 100/100 |
| Example 19 | 8 | 84.7 | 84.3 | 0.020 | 100/100 |
| Example 20 | 9 | 86.7 | 86.5 | 0.061 | 100/100 |
| Example 21 | 10 | 84.2 | 84.1 | 0.066 | 100/100 |
| Example 22 | 11 | 84.6 | 84.4 | 0.050 | 100/100 |
| Example 23 | 12 | 84.8 | 84.5 | 0.052 | 100/100 |
| Example 24 | 13 | 86.5 | 86.3 | 0.058 | 100/100 |
| Example 25 | 14 | 87.1 | 86.9 | 0.048 | 100/100 |
| Comparative Example 6 | 6r | 71.4 | 83.6 | 0.055 | 20/100 |
| Comparative Example 7 | 7r | - | 66.0 | 1.340 | - |
| Comparative Example 8 | 8r | - | 82.2 | 0.220 | 0/100 |

As shown in Table 6, when ions were implanted into the surface of the primer layer, the primer layer formed in Comparative Example 6 that did not contain the silicon-containing compound was colored, and had low total light transmittance as compared with those of Examples 12 to 25, and the resulting formed article 6r exhibited inferior adhesion and transparency.

The formed article 7r of Comparative Example 7 that did not include the gas barrier layer, and the formed article 8r of Comparative Example 8 in which the oxygen atom content rate, the nitrogen atom content rate, the silicon atom content rate, and the film density in the gas barrier layer were outside the ranges of the invention, had a high water vapor transmission rate and low total light transmittance (i.e., exhibited inferior transparency).

In contrast, the formed articles 12 to 25 obtained in Examples 12 to 25 including the primer layer containing the silicon-containing compound, and the gas barrier layer having an oxygen atom content rate of 60 to 75%, a nitrogen atom content rate of 0 to 10%, and a silicon atom content rate of 25 to 35%, based on the total content rate of oxygen atoms, nitrogen atoms, and silicon atoms, and having a film density of 2.4 to 4.0 $g/cm^3$, had high total light transmittance (i.e., exhibited excellent transparency). The formed articles 12 to 25 also exhibited excellent interlayer adhesion, and had a low water vapor transmission rate (i.e., exhibited an excellent gas barrier capability).

## Claims

1. A formed article sequentially comprising a base layer, a primer layer, and a gas barrier layer,

   the primer layer being formed of a material that includes at least a carbon atom, an oxygen atom, and a silicon atom, and is **characterized in that** a peak position of binding energy of 2p electrons of the silicon atom as determined by X-ray photoelectron spectroscopy (XPS) is 101.9 to 104 eV, and
   the gas barrier layer being a layer obtained by implanting ions into a polymer layer that includes at least one compound selected from a group consisting of a polysilazane compound, a polyorganosiloxane compound, a polycarbosilane compound, and a polysilane compound.

2. A formed article sequentially comprising a base layer, a primer layer that includes a silicon-containing compound, and a gas barrier layer,

   the primer layer being formed of a material that includes at least a carbon atom, an oxygen atom, and a silicon atom, and is **characterized in that** a peak position of binding energy of 2p electrons of the silicon atom as determined by X-ray photoelectron spectroscopy (XPS) is 101.9 to 104 eV,
   the gas barrier layer being formed of a material that includes at least an oxygen atom and a silicon atom, a surface layer part of the gas barrier layer having an oxygen atom content rate of 60 to 75%, a nitrogen atom content rate of 0 to 10%, and a silicon atom content rate of 25 to 35%, based on a total content rate of oxygen atoms, nitrogen atoms, and silicon atoms, and being obtained by implanting ions into a polysilazane compound-containing layer, and the surface layer part of the gas barrier layer having a film density of 2.4 to 4.0 g/$cm^3$.

3. The formed article according to claim 1 or 2, wherein an area of the primer layer up to a depth of 10 nm from an interface with the gas barrier layer has a carbon atom content rate of 5.0 to 65.0%, an oxygen atom content rate of 25.0 to 70.0%, and a silicon atom content rate of 3.0 to 30.0%, based on a total content rate of carbon atoms, oxygen atoms, and silicon atoms.

4. The formed article according to claim 1 or 2, wherein the polysilazane compound is perhydropolysilazane.

5. The formed article according to claim 1 or 2, wherein the ions are obtained by ionizing at least one gas selected from a group consisting of hydrogen, nitrogen, oxygen, argon, helium, neon, xenon, and krypton.

6. The formed article according to claim 1 or 2, wherein the ions are implanted by a plasma ion implantation method.

7. The formed article according to claim 1 or 2, the formed article having a water vapor transmission rate at a temperature of 40°C and a relative humidity of 90% of less than 0.50 g/$m^2$/day.

8. A method for forming the formed article according to claim 1, the method comprising:

   forming a primer layer on a base layer, the primer layer being formed of a material that includes at least a carbon atom, an oxygen atom, and a silicon atom, and is **characterized in that** a peak position of binding energy of 2p electrons of the silicon atom as determined by X-ray photoelectron spectroscopy (XPS) is 101.9 to 104 eV;
   forming a polymer layer on the primer layer, the polymer layer including at least one compound selected from a group consisting of a polysilazane compound, a polyorganosiloxane compound, a polycarbosilane compound, and a polysilane compound; and
   implanting ions into a surface area of the polymer layer to form a gas barrier layer.

9. The method according to claim 8, wherein the implanting includes implanting ions of at least one gas selected from a group consisting of hydrogen, nitrogen, oxygen, argon, helium, neon, xenon, and krypton.

10. The method according to claim 8, wherein the implanting includes implanting the ions by a plasma ion implantation method.

11. An electronic device member comprising the formed article according to claim 1 or 2.

12. An electronic device comprising the electronic device member according to claim 11.

## Patentansprüche

1. Geformter Gegenstand, sequenziell umfassend eine Basisschicht, eine Primerschicht und eine Gassperrschicht, wobei die Primerschicht gebildet ist aus einem Material, welches enthält: mindestens ein Kohlenstoffatom, ein Sauerstoffatom und ein Siliciumatom, und das **dadurch gekennzeichnet ist, dass** eine Peakposition der Bindungsenergie von 2p-Elektronen des Siliciumatoms, bestimmt durch Röntgenphotoelektronenspektroskopie (XPS), 101,9 bis 104 eV beträgt, und
wobei die Gassperrschicht eine Schicht ist, die erhalten wurde durch Implantieren von Ionen in eine Polymerschicht, welche enthält: mindestens eine Verbindung, ausgewählt aus einer Gruppe, bestehend aus einer Polysilazanverbindung, einer Polyorganosiloxanverbindung, einer Polycarbosilanverbindung und einer Polysilanverbindung.

2. Geformter Gegenstand, sequenziell umfassend eine Basisschicht, eine Primerschicht, die eine Silicium-enthaltende Verbindung enthält, und eine Gassperrschicht,
wobei die Primerschicht gebildet ist aus einem Material, welches enthält: mindestens ein Kohlenstoffatom, ein Sauerstoffatom und ein Siliciumatom, und das **dadurch gekennzeichnet ist, dass** eine Peakposition der Bindungsenergie von 2p-Elektronen des Siliciumatoms, bestimmt durch Röntgenphotoelektronenspektroskopie (XPS), 101,9 bis 104 eV beträgt,
wobei die Gassperrschicht gebildet ist aus einem Material, das enthält: mindestens ein Sauerstoffatom und ein Siliciumatom, wobei ein Oberflächenschichtteil der Gassperrschicht eine Sauerstoffatomgehaltsrate von 60 bis 75%, eine Stickstoffatomgehaltsrate von 0 bis 10% und eine Siliciumatomgehaltsrate von 25 bis 35%, bezogen auf die Gesamtgehaltsrate von Sauerstoffatomen, Stickstoffatomen und Siliciumatomen, aufweist und erhalten wird durch Implantieren von Ionen in eine Polysilazanverbindung-enthaltende Schicht, und wobei der Oberflächenschichtteil der Gassperrschicht eine Filmdichte von 2,4 bis 4,0 $g/cm^3$ aufweist.

3. Geformter Gegenstand nach Anspruch 1 oder 2, wobei eine Region der Primerschicht bis zu einer Tiefe von 10 nm von der Grenzfläche mit der Gassperrschicht eine Kohlenstoffatomgehaltsrate von 5,0 bis 65,0%, eine Sauerstoffatomgehaltsrate von 25,0 bis 70,0% und eine Siliciumatomgehaltsrate von 3,0 bis 30,0%, bezogen auf eine Gesamtgehaltsrate von Kohlenstoffatomen, Sauerstoffatomen und Siliciumatomen, aufweist.

4. Geformter Gegenstand nach Anspruch 1 oder 2, wobei die Polysilazanverbindung Perhydropolysilazan ist.

5. Geformter Gegenstand nach Anspruch 1 oder 2, wobei die Ionen erhalten werden durch Ionisieren von mindestens einem Gas, ausgewählt aus der Gruppe, bestehend aus Wasserstoff, Stickstoff, Sauerstoff, Argon, Helium, Neon, Xenon und Krypton.

6. Geformter Gegenstand nach Anspruch 1 oder 2, wobei die Ionen implantiert werden durch ein Plasmaionenimplantierungsverfahren.

7. Geformter Gegenstand nach Anspruch 1 oder 2, wobei der geformte Gegenstand eine Wasserdampfdurchlässigkeitsrate bei einer Temperatur von 40°C und einer relativen Luftfeuchtigkeit von 90% von weniger als 0,50 $g/m^2$/Tag aufweist.

8. Verfahren zur Herstellung des geformten Gegenstands nach Anspruch 1, wobei das Verfahren umfasst:

   das Bilden einer Primerschicht auf einer Basisschicht, wobei die Primerschicht gebildet wird aus einem Material, das enthält: mindestens ein Kohlenstoffatom, ein Sauerstoffatom und ein Siliciumatom und das **dadurch gekennzeichnet ist, dass** eine Peakposition der Bindungsenergie von 2p-Elektronen des Siliciumatoms, bestimmt durch Röntgenphotoelektronenspektroskopie (XPS), 101,9 bis 104 eV beträgt;
   das Bilden einer Polymerschicht auf der Primerschicht, wobei die Polymerschicht enthält: mindestens eine Verbindung, ausgewählt aus einer Gruppe, bestehend aus einer Polysilazanverbindung, einer Polyorganosiloxanverbindung, einer Polycarbosilanverbindung, und einer Polysilanverbindung; und
   das Implantieren von Ionen in eine Oberflächenregion der Polymerschicht, um eine Gassperrschicht zu bilden.

9. Verfahren nach Anspruch 8, wobei das Implantieren umfasst: Implantieren von Ionen von mindestens einem Gas, ausgewählt aus einer Gruppe, bestehend aus Wasserstoff, Stickstoff, Sauerstoff, Argon, Helium, Neon, Xenon und Krypton.

10. Verfahren nach Anspruch 8, wobei das Implantieren umfasst: das Implantieren der Ionen durch ein Plasmaionenimplantierungsverfahren.

11. Elektronisches Vorrichtungselement, umfassend den geformten Gegenstand nach Anspruch 1 oder 2.

12. Elektronische Vorrichtung, umfassend das elektronische Vorrichtungselement nach Anspruch 11.

**Revendications**

1. Article formé comprenant séquentiellement une couche de base, une couche d'amorçage et une couche étanche aux gaz,
la couche d'amorçage étant constituée d'un matériau qui comprend au moins un atome de carbone, un atome d'oxygène et un atome de silicium, et est **caractérisée en ce qu'**une position de pointe d'énergie de liaison d'électrons 2p de l'atome de silicium, déterminée par spectroscopie photoélectronique X (XPS) est de 101,9 à 104 eV, et
la couche étanche aux gaz étant une couche obtenue en implantant des ions dans une couche de polymère qui comprend au moins un composé choisi dans un groupe constitué par un composé de polysilazane, un composé de polyorganosiloxane, un composé de polycarbosilane et un composé de polysilane.

2. Article formé comprenant séquentiellement une couche de base, une couche d'amorçage qui comprend un composé contenant du silicium, et une couche étanche aux gaz,
la couche d'amorçage étant constituée d'un matériau qui comprend au moins un atome de carbone, un atome d'oxygène, et un atome de silicium et est **caractérisée en ce qu'**une position de pointe d'énergie de liaison d'électrons 2p de l'atome de silicium, déterminée par spectroscopie photoélectronique X (XPS) est de 101,9 à 104 eV,
la couche étanche aux gaz étant constituée d'un matériau qui comprend au moins un atome d'oxygène et un atome de silicium, une partie superficielle de couche de la couche étanche aux gaz ayant un taux de teneur en atome d'oxygène de 60 à 75 %, un taux de teneur en atome d'azote de 0 à 10 %, et un taux de teneur en atome de silicium de 25 à 35 %, sur la base d'un taux de teneur total en atomes d'oxygène, en atomes d'azote et en atomes de silicium, et étant obtenue en implantant des ions dans une couche contenant un composé de polysilazane, et la partie superficielle de couche de la couche étanche aux gaz ayant une densité de film de 2,4 à 4,0 g/$cm^3$.

3. Article formé selon la revendication 1 ou 2, dans lequel une zone de la couche d'amorçage jusqu'à une profondeur de 10 nm depuis une interface avec la couche étanche aux gaz a un taux de teneur en atome de carbone de 5,0 à 65,0 %, un taux de teneur en atome d'oxygène de 25,0 à 70,0 % et un taux de teneur en atome de silicium de 3,0 à 30,0 %, sur la base d'un taux de teneur total en atomes de carbone, en atomes d'oxygène et en atomes de silicium.

4. Article formé selon la revendication 1 ou 2, dans lequel le composé de polysilazane est le perhydropolysilazane.

5. Article formé selon la revendication 1 ou 2, dans lequel les ions sont obtenus en ionisant au moins un gaz choisi dans un groupe constitué par l'hydrogène, l'azote, l'oxygène, l'argon, l'hélium, le néon, le xénon et le krypton.

6. Article formé selon la revendication 1 ou 2, dans lequel les ions sont implantés par un procédé d'implantation ionique par plasma.

7. Article formé selon la revendication 1 ou 2, l'article formé ayant une vitesse de transmission de la vapeur d'eau à une température de 40 °C et à une humidité relative de 90 %, inférieure à 0,50 g/$m^2$/jour.

8. Procédé de formation de l'article formé selon la revendication 1, le procédé consistant à :

former une couche d'amorçage sur une couche de base, la couche d'amorçage étant constituée d'un matériau qui comprend au moins un atome de carbone, un atome d'oxygène et un atome de silicium, et est **caractérisée en ce qu'**une position de pointe d'énergie de liaison d'électrons 2p de l'atome de silicium, déterminée par spectroscopie photoélectronique X (XPS), est de 101,9 à 104 eV ;
former une couche de polymère sur la couche d'amorçage, la couche de polymère comprenant au moins un composé choisi dans un groupe constitué par un composé de polysilazane, un composé de polyorganosiloxane, un composé de polycarbosilane et un composé de polysilane ; et
implanter des ions dans une zone superficielle de la couche de polymère pour former une couche étanche aux gaz.

**9.** Procédé selon la revendication 8, dans lequel l'implantation consiste à implanter des ions d'au moins un gaz choisi dans un groupe constitué par l'hydrogène, l'azote, l'oxygène, l'argon, l'hélium, le néon, le xénon et le krypton.

**10.** Procédé selon la revendication 8, dans lequel l'implantation consiste à implanter les ions par un procédé d'implantation ionique par plasma.

**11.** Élément pour dispositif électronique comprenant l'article formé selon la revendication 1 ou 2.

**12.** Dispositif électronique comprenant l'élément pour dispositif électronique selon la revendication 11.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2010067857 A
- JP 2003154596 A
- JP 2006264118 A
- US 2006232735 A1
- JP 2007237588 A
- JP 63016325 B
- JP 2195024 A
- JP 2084437 A
- JP 63081122 A
- JP 1138108 A
- JP 2175726 A
- JP 5238827 A
- JP 6122852 A
- JP 6306329 A
- JP 6299118 A
- JP 9031333 A
- JP 5345826 A
- JP 4063833 A
- JP 9143289 A
- JP 51126300 A
- JP 2006117917 A
- JP 2001328991 A
- WO 9829476 A
- JP 4334551 A
- JP 2001026887 A
- JP 2001156013 A
- WO 2010021326 A


### Non-patent literature cited in the description


- *Journal of Materials Science,* 1978, vol. 13, 2569-2576
- *Organometallics,* 1991, vol. 10, 1336-1344
- *Journal of Organometallic Chemistry,* 1996, vol. 521, 1-10
- **R. D. MILLER ; J. MICHL.** *Chemical Review,* 1989, vol. 89, 1359
- **N. MATSUMOTO.** *Japanese Journal of Physics,* 1998, vol. 37, 5425
- *J. Am. Chem. Soc.,* 1988, vol. 110, 124
- *Macromolecules,* 1990, vol. 23, 3423
- *J. Chem. Soc., Chem. Commun.,* 1990, 1161
- *J. Chem. Soc., Chem. Commun.,* 1992, 897
- *Macromolecules,* 1990, vol. 23, 4494